(19) Europäisches Patentamt
European Patent Office
Office européen des brevets

(11) **EP 3 540 878 B1**

(12) **FASCICULE DE BREVET EUROPEEN**

(45) Date de publication et mention de la délivrance du brevet:
**14.10.2020 Bulletin 2020/42**

(51) Int Cl.:
**H01S 5/12** *(2006.01)*    **H01S 5/02** *(2006.01)*
**H01S 5/026** *(2006.01)*    **H01S 5/10** *(2006.01)*

(21) Numéro de dépôt: **19161903.0**

(22) Date de dépôt: **11.03.2019**

(54) **DISPOSITIF PHOTONIQUE COMPORTANT UN LASER OPTIQUEMENT CONNECTÉ À UN GUIDE D ONDE SILICIUM ET PROCÉDÉ DE FABRICATION D'UN TEL DISPOSITIF PHOTONIQUE**

PHOTONENVORRICHTUNG, DIE EINEN LASER UMFASST, DER OPTISCH MIT EINEM SILIZIUM-WELLENLEITER VERBUNDEN IST, UND HERSTELLUNGSVERFAHREN EINER SOLCHEN PHOTONENVORRICHTUNG

PHOTONIC DEVICE INCLUDING A LASER OPTICALLY CONNECTED TO A SILICON WAVEGUIDE AND METHOD FOR MANUFACTURING SUCH A PHOTONIC DEVICE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **12.03.2018 FR 1852120**

(43) Date de publication de la demande:
**18.09.2019 Bulletin 2019/38**

(73) Titulaire: **Commissariat à l'énergie atomique et aux énergies alternatives 75015 Paris (FR)**

(72) Inventeurs:
• **MENEZO, Sylvie**
  **38054 GRENOBLE Cedex 09 (FR)**
• **THIESSEN, Torrey**
  **TORONTO, Ontario M5R 2K2 (CA)**

(74) Mandataire: **Brevalex**
  **95, rue d'Amsterdam**
  **75378 Paris Cedex 8 (FR)**

(56) Documents cités:
**EP-A1- 2 988 378        US-A1- 2007 133 648
US-A1- 2015 270 684**

• **KEYVANINIA S ET AL: "Heterogeneously integrated III-V/silicon distributed feedback lasers", OPTICS LETTERS, OPTICAL SOCIETY OF AMERICA, US, vol. 38, no. 24, 15 décembre 2013 (2013-12-15), pages 5434-5437, XP001587456, ISSN: 0146-9592, DOI: 10.1364/OL.38.005434 [extrait le 2013-12-12]**
• **DUPREZ HELENE ET AL: "Hybrid III-V on Silicon Laterally Coupled Distributed Feedback Laser Operating in the $O$ -Band", IEEE PHOTONICS TECHNOLOGY LETTERS, IEEE SERVICE CENTER, PISCATAWAY, NJ, US, vol. 28, no. 18, 15 septembre 2016 (2016-09-15), pages 1920-1923, XP011615748, ISSN: 1041-1135, DOI: 10.1109/LPT.2016.2576021 [extrait le 2016-07-01]**

EP 3 540 878 B1

## Description

## DOMAINE TECHNIQUE

L'invention concerne le domaine de l'optoélectronique et des dispositifs de la photonique.
L'invention a plus précisément pour objet un dispositif photonique comportant un guide d'onde destiné à accommoder plusieurs composants photoniques silicium et un laser hybride sur silicium comprenant un milieu à gain apte à émettre de la lumière.

## ÉTAT DE LA TECHNIQUE ANTÉRIEURE

La fabrication de dispositifs photoniques hybrides intégrant des composants photoniques silicium et au moins un laser hybride sur silicium comprenant un milieu à gain apte à émettre de la lumière, tels qu'un milieu à gain réalisé en matériaux semiconducteurs III-V, doit nécessairement prendre en compte les contraintes de conceptions en ce qui concerne le dimensionnement du premier guide d'onde en silicium accommodant les composants photoniques silicium et du deuxième guide d'onde en silicium rentrant dans la composition du laser hybride. Un tel laser hybride comprend généralement :

- une structure à gain comportant au moins un milieu à gain apte à émettre de la lumière, la structure à gain étant sus-jacente à une section du deuxième guide d'onde silicium pour former avec celle-ci un guide d'onde hybride,
- une structure de contre réaction optique permettant de former une cavité résonante comprenant le milieu à gain de ladite structure à gain,
- et des transitions optiques entre le deuxième guide d'onde Silicium et le guide d'onde hybride.

On entend ci-dessus et dans le reste de ce document par « structure à gain », une structure à matériaux semiconducteurs adaptée pour fournir une émission de lumière pouvant être notamment stimulée afin de fournir une émission du type laser lorsqu'une telle structure est couplée à une structure de contre réaction optique, telle qu'un réseau de Bragg distribué le long de ladite structure à gain. Une telle structure à gain comporte au moins un milieu à gain, qui est le matériau dans lequel l'émission de lumière est générée, et, de part et d'autre, une première et deuxième zone présentant chacune un type de conductivité opposé à celui de l'autre pour autoriser un pompage électrique du milieu à gain. Dans une application classique de lasers à matériaux semiconducteurs, notamment pour fournir une émission dans les gammes de longueurs d'onde de l'infrarouge et en particulier aux longueurs d'onde 1310 nm et 1550 nm, les première et deuxième zones et le milieu à gain sont formés par croissance épitaxiale sur des substrats en phosphure d'indium InP ou en arséniure de gallium GaAs. En effet, la faible différence de maille de ces matériaux avec leurs alliages quaternaires permet de fournir des première et deuxième zones et un milieu à gain de bonne qualité cristalline idéaux pour optimiser le rendement d'émission laser.
Le milieu à gain d'une telle structure à gain peut comporter une succession de puits quantiques fournissant l'émission de lumière. Afin d'augmenter le facteur de confinement du mode optique dans les puits quantiques, ceux-ci sont généralement encadrés par deux couches de barrière. En variante aux puits quantiques, le milieu à gain peut également comporter des boîtes quantiques. Afin de former de tels puits quantiques, ou boîtes quantiques, et dans une configuration classique d'un tel laser hybride, le milieu à gain peut comporter au moins deux matériaux semiconducteurs sélectionnés par exemple dans le groupe comportant le phosphure d'indium InP, l'arséniure de gallium GaAs, l'arséniure d'indium InAs, l'arséniure-phosphure de gallium-indium InGaAsP, l'arséniure de gallium-indium-aluminium InGaAlAs, l'arséniure d'aluminium-gallium AlGaAs et l'arséniure-phosphure d'indium InAsP et leurs alliages. De la même façon, la première et la deuxième zone peuvent être réalisées dans au moins un matériau semiconducteur sélectionné dans le groupe comportant le phosphure d'indium InP, l'arséniure de gallium GaAs, l'arséniure de gallium-indium InGaAs, l'arséniure d'indium InAs, l'arséniure-phosphure de gallium-indium InGaAsP, l'arséniure de gallium-indium-aluminium InGaAlAs, l'arséniure-nitrure d'aluminium-indium InAlAsN, l'arséniure d'aluminium-gallium AlGaAs et l'arséniure-phosphure d'indium InAsP et leurs alliages, l'une de la première et la deuxième zone étant d'un premier type de conductivité dans lequel les porteurs majoritaires sont les électrons, l'autre étant d'un deuxième type de conductivité dans lequel les porteurs majoritaires sont les trous.
De telles structures à gain peuvent être soit du type « vertical » soit du type « latéral». Dans le premier cas, c'est-à-dire une structure à gain du type « vertical », la première zone, le milieu à gain et la deuxième zone sont constituées par un empilement de couches à la surface d'un support. Dans une telle configuration, l'épaisseur de l'empilement formant structure à gain est généralement comprise entre 1 à 3 $\mu$m. Dans le second cas, c'est-à-dire une structure à gain du type « latéral », la première zone, le milieu à gain, et la deuxième zone se succède en contact le long d'un support. L'épaisseur typique d'une structure à gain du type latéral est de l'ordre de 500 nm.
On entend ci-dessus et dans le reste de ce document par « structure de contre réaction optique », une structure optique réalisée dans un guide d'onde et permettant de former une cavité résonante guidante comprenant le milieu à gain. Ainsi, le champ optique effectue des allers-retours dans le guide d'onde de la cavité entre les extrémités de cette même cavité résonante ceci pour générer une émission stimulée du milieu à gain.
Dans le cadre de l'invention, le laser est un laser dit à contre réaction répartie (ou Distributed Feedback Laser en anglais connu sous l'acronyme laser DFB). Dans une telle configuration, la structure de contre réaction optique est constituée par un réflecteur distribué, tel qu'un réseau de Bragg, sous ou dans la structure à gain, formant un miroir sélectif en longueur d'onde.

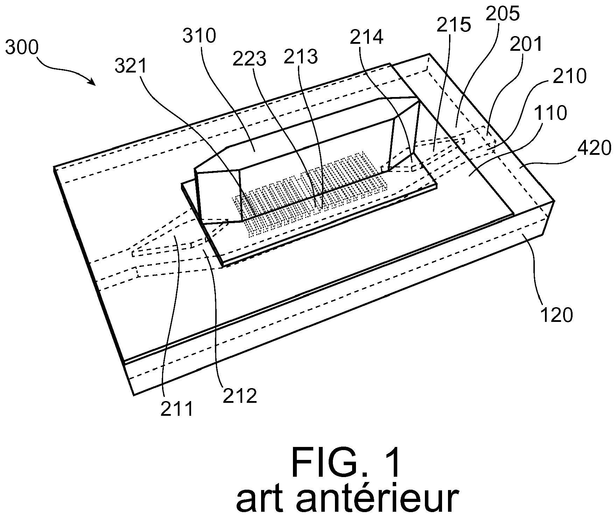

S. Keyvaninia et ses coauteurs décrivent dans leurs travaux publiés en 2013 dans la revue scientifique « Optics Letters » volume 38 numéro 24 pages 5434 à 5437, un dispositif photonique comportant un tel laser. Comme illustré sur la figure 1a) de ce document reproduite ici par la figure 1, ce dispositif comporte :

- un support 120,
- une couche intermédiaire 420 réalisée en dioxyde de silicium SiO$_2$, la couche intermédiaire 420 étant en contact avec le support 120,
- une couche en matériau silicium 201,
- un premier guide d'onde 210 formé dans la couche 201,
- des première à cinquième sections de guide d'onde 211, 212, 213, 214, 215 formées dans la couche 201, la première à la cinquième section de guide d'onde 211, 212, 213, 214, 215 se succédant en étant connectées optiquement deux à deux, et étant connectées optiquement au premier guide d'onde 210 par au moins l'une de la première et de la cinquième section de guide d'onde 211, 215,
- un matériau diélectrique de remplissage 205 de manière à former avec le guide d'onde et la première à la cinquième section de guide d'onde un étage de guidage d'onde 200 du dispositif photonique 1,
- une première couche diélectrique 110, formée dans ce document par du benzocyclobutène (plus connu sous le sigle BCB), la première couche diélectrique 110 recouvrant l'étage de guidage optique à l'opposé de à la couche intermédiaire 420,
- une structure à gain 310 en contact avec la première couche diélectrique 110 et comportant au moins un milieu à gain 321 apte à émettre de la lumière, la structure à gain 310 présentant une portion centrale en regard de la troisième section de guide d'onde 213 et une première et une deuxième extrémité en regard des deuxième et quatrième section de guide d'onde 212, 214, ainsi, la portion centrale de la structure à gain 310 forme avec la troisième section de guide d'onde 213 un guide d'onde hybride laser, les deuxième et quatrième section de guide d'onde 212, 214 et les premières et deuxième extrémités de la structure à gain 310 formant une première et une deuxième zone de transition optique d'un mode optique entre le guide d'onde hybride laser et respectivement la première et la cinquième section de guide d'onde 211, 215.

Afin de former un laser DFB, la troisième section de guide d'onde comprend une structuration aménagée, ladite structuration formant un réseau de Bragg 223 distribué sous la structure à gain pour former une structure de contre réaction et une cavité résonante comprenant au moins une partie du milieu à gain 321. Selon une configuration classique, le réseau de Bragg 223 décrit dans ce document est constitué, comme le montre la figure 1, par une alternance de sections transversales relativement larges, dites arêtes larges de largeur WL et de section transversale relativement étroite, dites arêtes étroites de largeur WN inférieure à WL, de la troisième section de guide d'onde. Dans la configuration du réseau de Bragg 223 représentée en figure 1, la largeur WN est nulle.

Il est à noter que dans le reste de ce document, un réseau de Bragg 223 dont la largeur WN des arêtes étroites sont nulle est noté réseau de Bragg à corrugation ou structuration verticale.

La structuration formant le réseau de Bragg est aménagée dans une partie de l'épaisseur de la troisième section de guide d'onde 213 qui est en contact avec la couche diélectrique 110.

Avec un tel réseau de Bragg, il est possible de définir une force de contre-réaction de nommé kappa et noté k$_g$,. Cette force de contre réaction peut être calculée, si on considère des arêtes larges et étroites de mêmes longueurs, à partir de l'équation suivante :

$$(1) \ K_g = \frac{2(neff2 - neff1)}{\lambda}$$

Avec $\lambda$ la longueur d'onde de résonance de la cavité résonnante, neff1 et neff2 les indices effectifs du mode optique guidé dans le guide d'onde hybride aux niveaux de respectivement des arêtes larges et des arêtes étroites (c'est-à-dire, la largeur WN étant nulle, les creux sur la figure 1).

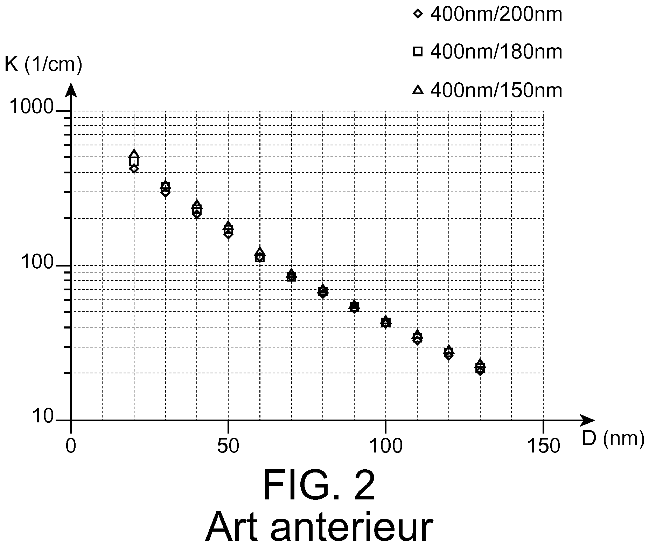

S. Keyvaninia et ses coauteurs ont montré par le graphique de la figure 2 fourni dans leurs travaux qui est repris en figure 2, que la valeur kappa augmente lorsque l'épaisseur D de la première couche diélectrique 110 diminue.

Pour faire leur calcul, S. Keyvaninia et ses coauteurs ont utilisé la configuration suivante : épaisseur de la couche de silicium 201 de 400 nm, épaisseur du premier guide d'onde 210 de 220 nm, épaisseur du deuxième guide d'onde, dont la troisième section de guide d'onde 213, de 400 nm et épaisseur des arêtes fixées pour des premiers calculs (notés 400 nm/150 nm) à 250 nm, pour des deuxièmes calculs (notés 400 nm/180 nm) à 220 nm et pour des troisièmes calculs (notés 400 nm/200 nm) à 200 nm.

Le graphique représenté sur la figure 2 rapporte le calcul de kappa en fonction de l'épaisseur D pour ces trois types de corrugation (épaisseurs d'arêtes de 250 nm, 220 nm et 200 nm). La valeur minimale de kappa est ainsi égale à 40 cm$^{-1}$, pour une épaisseur de la couche intermédiaire 420 de 100 nm, et atteint près de 200 cm$^{-1}$ pour une épaisseur de 50 nm de cette même couche et dépasse les 400 cm$^{-1}$ pour une épaisseur de 20 nm.

Les auteurs de cette publication montrent également qu'il est possible de diminuer la force de contre-réaction du réseau de Bragg en modifiant le rapport de volume entre des zones de la troisième section de guide d'onde présentant les arêtes larges et celles présentant les arêtes étroites, en modifiant l'épaisseur des arêtes mais cette variation reste limitée, comme le montre la figure 2.

Or, cette force de contre-réaction doit être adaptée en fonction du dimensionnement de la structure à gain 310. En effet, pour un bon fonctionnement d'un laser comportant une structure à gain présentant respectivement une longueur de 500 $\mu$m et de 1000 $\mu$m, il est connu que la force de contre-réaction doit être comprise entre respectivement 20 et 40 cm$^{-1}$ et entre 10 et 20 cm$^{-1}$. On notera que, plus généralement, le produit Kappa par la longueur de la structure à gain doit être compris entre 1 et 2.

Ainsi, en raison de ces contraintes de dimensionnement, il n'est pas possible avec la configuration usuelle d'un dispositif photonique, comme celle proposée par S. Keyvaninia et ses coauteurs, de fournir un laser DFB présentant à la fois une structure à gain avec une longueur importante et une épaisseur de la première couche diélectrique 110 relativement faible, c'est-à-dire inférieure à 100 nm.

H. Duprez et ses coauteurs, dans le cadre de leurs travaux publiés en 2016 dans la revue scientifique « IEEE Photonics Technology Letter» Volume 28 numéro 18 pages 1920 à 1923 ont également fait les mêmes observations. Dans le dispositif photonique décrit dans leurs travaux, la configuration employée est la suivante : épaisseur de la couche de silicium 201 de 500 nm, épaisseur du premier guide d'onde 210 de 300 nm, épaisseur du deuxième guide d'onde de 500 nm. Le réseau de Bragg 223 est réalisé par une structuration par alternance d'arêtes larges de largeur WL tour à tour égales à 770, 800, et 830 nm et d'arêtes étroites de largeur tout à tour égales à 370 et 600 nm, les arêtes étant formées dans une épaisseur de 200 nm de la couche de silicium 20 qui est en contact avec la couche diélectrique 110

Il est à noter que dans le reste de ce document, qu'une telle configuration dans laquelle le réseau de Bragg 223 présente une largeur WN des arêtes étroites non nulle est noté réseau de Bragg à corrugation ou structuration latérale.

De la même manière que pour une corrugation verticale, il est possible de définir pour une structuration latérale une force de contre-réaction du réseau de Bragg à partir de l'équation (1).

Il est à noter que les auteurs s'imposent ici de choisir des arêtes larges présentant une largeur WL autour de 800 nm car, comme il est connu de l'homme de l'art, pour minimiser les pertes optiques entre le guide d'onde hybride laser et les premières et deuxièmes zones de transitions optiques, pour une structure active 310 d'épaisseur environ 3 $\mu$m, et pour des deuxième, troisième et quatrième sections de guide d'onde 212, 213 et 214 d'épaisseur totale 500 nm, il est préférable d'avoir une largeur WL des arête large supérieure à environ 800 nm. De ce fait, il n'est donc pas possible de bénéficier de la variation de forces de contre-réaction du réseau de Bragg, montrée sur la figure 2 (voir notamment la figure 2a) de l'article de H. Duprez et ces coauteurs, que permet la réduction de la largeur WL des arêtes larges.

H. Duprez et ses coauteurs montrent qu'il est possible de diminuer la force de contre-réaction du réseau de Bragg en modifiant le rapport de volume entre les arêtes larges et les arêtes étroites, en augmentant la largeur de l'arête étroite. Néanmoins, cette variation reste limitée, comme le montre la comparaison des figures 2b et 2c de ce document. Ainsi même une optimisation de ce rapport n'autorise pas la fourniture un laser DFB présentant à la fois une structure à gain avec une longueur importante, c'est-à-dire supérieure à 50 $\mu$m, et une épaisseur de la première couche diélectrique 110 relativement faible, c'est-à-dire inférieure à 100 nm.

On notera également que le dispositif photonique enseigné par H. Duprez et ces coauteurs possède une force de contre réaction présentant une forte variabilité aux dispersions de largeur des arêtes larges et étroites.

De façon similaire, le document EP 2988378 présente une configuration alternative à tel dispositif photonique, le dispositif qu'il divulgue présente le même inconvénient et ne permet pas d'aboutir, pour des faibles épaisseurs de la première couche diélectrique séparant la troisième section de guide d'onde de la structure à gain, à une force de contre-réaction du réseau de Bragg adaptée pour des longueurs de structure à gain supérieures à 50 $\mu$m.

Ainsi dans les dispositifs existants et pour des épaisseurs de première couche diélectrique inférieures à 100 nm, la force de contreréaction du réseau de Bragg 223 ne peut pas être ajustée à une valeur suffisamment basse, même en modifiant le rapport de volume entre les arêtes larges et étroites.

## EXPOSÉ DE L'INVENTION

L'invention vise à remédier à cet inconvénient et a ainsi pour but de fournir un dispositif photonique à même de comporter un laser comprenant une structure à gain d'une longueur supérieure à 50 $\mu$m, voire 500 $\mu$m, ou encore 1000 $\mu$m, ceci avec une première couche diélectrique qui, séparant la structure à gain de la troisième section de guide d'onde dans laquelle est formé un réseau de Bragg distribué, présente une épaisseur inférieure ou égale à 120 nm voire 50 nm ou encore 10 nm.

A cet effet, l'invention concerne un dispositif photonique comportant :

- un support,
- une couche intermédiaire en contact avec le support comportant au moins un matériau diélectrique,
- un premier guide d'onde,

- une première à une cinquième section de guide d'onde distinctes du premier guide d'onde, la première à la cinquième section de guide d'onde se succédant en étant connectées optiquement deux à deux, et étant connectées optiquement au premier guide d'onde par au moins l'une de la première et de la cinquième section de guide d'onde,
- un matériau diélectrique de remplissage, pour former avec le premier guide d'onde et la première à la cinquième section de guide d'onde un étage de guidage d'onde du dispositif photonique, l'étage de guidage optique comprenant une première face par laquelle il est en contact avec la couche intermédiaire et une deuxième face opposée à la première face,
- une première couche diélectrique comportant un matériau diélectrique, la première couche diélectrique recouvrant l'étage de guidage optique sur sa deuxième face,
- une structure à gain en contact avec la première couche diélectrique et comportant au moins un milieu à gain apte à émettre de la lumière, la structure à gain présentant une portion centrale en regard de la troisième section de guide d'onde et une première et une deuxième extrémité en regard des deuxième et quatrième sections de guide d'onde, ainsi, la portion centrale de la structure à gain forme avec la troisième section de guide d'onde un guide d'onde hybride laser, les deuxième et quatrième sections de guide d'onde et les première et deuxième extrémités de la structure à gain formant une première et une deuxième zone de transition optique d'un mode optique entre le guide d'onde hybride laser et respectivement la première et la cinquième sections de guide d'onde,

dans lequel la troisième section est en contact avec la couche intermédiaire et comprend une structuration aménagée uniquement dans une première partie de son épaisseur, ladite structuration formant un réseau de Bragg distribué sous la structure à gain pour former une structure de contre réaction et une cavité résonante comprenant au moins une partie du milieu à gain ceci de manière à former un laser connecté optiquement au guide d'onde par au moins l'une de la première et la cinquième section de guide d'onde,

dans lequel les deuxième et quatrième sections de guide d'onde sont en contact avec la couche intermédiaire sur une partie de la couche intermédiaire qui est constituée uniquement de matériaux diélectriques.

La troisième section de guide d'onde comprend au moins une deuxième partie de son épaisseur qui sépare la première couche diélectrique et la première partie de l'épaisseur de la troisième section de guide d'onde.

Dans un tel dispositif photonique, l'aménagement de la structuration formant le réseau de Bragg sur une première partie de l'épaisseur de la troisième section de guide d'onde située à distance de la première couche diélectrique, et donc à distance de la structure à gain, permet d'obtenir une réduction importante de la force de contre-réaction du réseau de Bragg vis-à-vis de l'art antérieur. Cette réduction est suffisante pour aboutir à une force de contre-réaction adaptée pour les structures gain de longueur importante, c'est-à-dire supérieure à 50 $\mu$m, ceci même pour des premières couches diélectriques de faible épaisseur, c'est-à-dire inférieure ou égale à 100 nm.

On notera également, qu'un tel aménagement du réseau de Bragg permet également de rendre moins sensible la valeur de kappa aux inhomogénéités de largeurs des arêtes larges et étroites.

La première partie de l'épaisseur de la troisième section de guide d'onde peut être en contact avec la couche intermédiaire.

La troisième section de guide d'onde peut comprendre au moins une troisième partie de son épaisseur, ladite troisième partie d'épaisseur étant en contact avec la couche intermédiaire.

L'épaisseur de la première couche diélectrique peut être inférieure ou égale à 100 nm, l'épaisseur de la première couche diélectrique étant préférentiellement inférieure ou égale à 90 nm, voire à 70 nm, voire à 20 nm.

Un dispositif présentant une tel première couche diélectrique bénéficie particulièrement des avantages de l'invention qui est de fournir un réseau de Bragg distribué pouvant présenter une force de contre réaction adaptée pour de telles épaisseurs de la première couche diélectrique.

La troisième section de guide d'onde peut s'étendre longitudinalement le long d'un axe de propagation optique du dispositif optique,

la structuration de la troisième section consistant en une alternance entre une section transversale d'une première largeur et une section transversale d'une seconde largeur différente de la première largeur.

La seconde largeur peut être de valeur nulle.

La structure à gain peut s'étendre longitudinalement selon un axe de propagation optique du dispositif optique,

et chacune de la première et de la deuxième extrémité de la structure à gain peut présenter, sur au moins une partie de son épaisseur et selon une direction longitudinale allant en s'éloignant de la portion centrale, une section transversale de largeur décroissante.

Une telle variation de section aux deux extrémités, et sur une partie de l'épaisseur, de la structure à gain est particulièrement adaptée à une épaisseur de couche de silicium 201 inférieure à 700 nm, ou inférieure à 500 nm, et pouvant être égale à 400 nm, voire 300 nm.

La structure à gain peut s'étendre longitudinalement selon un axe de propagation optique du dispositif optique et comporter une première zone semiconductrice, une deuxième zone semiconductrice et le milieu à gain,

et, pour chacune de la première et la deuxième extrémité de la structure à gain, la première zone semiconductrice, la deuxième zone semiconductrice et le milieu gain peuvent présenter, sur leur longueur respective, une section transversale de largeur constante.

Une telle section transversale constante de la première zone semiconductrice, de la deuxième zone semiconductrice et du milieu gain permet de fournir des zones de transitions particulièrement adaptées à une épaisseur de couche de silicium 201 supérieure à 500 nm, et par exemple égale à 700 nm.

Le guide d'onde peut accommoder au moins un composant optique et/ou électronique,
le composant optique étant préférentiellement choisi dans le groupe comportant les modulateurs optiques silicium à jonction PN, les modulateurs hybrides semiconducteur III-V sur silicium, les réseaux de couplage surfaciques, les coupleurs à fibre par la tranche du dispositif, les filtres optiques, les multiplexeurs et démultiplexeurs en longueurs d'onde, et les photodétecteurs dont font partie les photodétecteurs germanium sur silicium et les photodétecteurs semiconducteur III-V sur silicium, et le composant électronique étant préférentiellement un transistor.

Le composant accommodé par le guide d'onde peut être un modulateur hybride semiconducteur III-V sur silicium, ledit modulateur étant un modulateur capacitif.

L'invention concerne également un procédé de fabrication d'un dispositif photonique comportant au moins un guide d'onde en silicium et un laser comprenant un milieu à gain apte à émettre de la lumière, le procédé comportant les étapes suivantes :

- fourniture d'un substrat associé avec au moins une couche de silicium sur une première couche diélectrique,
- formation, au moins en partie dans la couche de silicium, d'un premier guide d'onde et des première à cinquième sections de guide d'onde distinctes du premier guide d'onde, la première à la cinquième section de guide d'onde se succédant connectées optiquement deux à deux, et étant connectées optiquement au premier guide d'onde par au moins l'une de la première et la cinquième section de guide d'onde, la troisième section comprenant une structuration aménagée uniquement sur une première partie de son épaisseur, ladite structuration formant un réseau de Bragg,
- enterrement du guide d'onde et des première à cinquième section de guide d'onde par au moins un matériau diélectrique de remplissage et planarisation dudit matériau diélectrique de remplissage afin de former un étage de guidage optique comprenant le guide d'onde et les première à cinquième section de guide d'onde et une couche intermédiaire en contact avec ledit étage de guidage optique, la troisième section étant en contact avec la couche intermédiaire, les deuxième et quatrième section de guide d'onde étant en contact avec la couche intermédiaire sur une partie de la couche intermédiaire qui est constituée uniquement de matériaux diélectriques, un ensemble substrat/ première couche diélectrique/ étage de guidage optique/ couche intermédiaire étant ainsi formé,

- fourniture d'un support,
- assemblage de l'ensemble substrat/ première couche diélectrique/ étage de guidage optique/ couche intermédiaire sur le support, l'assemblage étant réalisé par collage de la couche intermédiaire sur le support,
- suppression du substrat,
- formation d'une structure à gain comportant au moins le milieu à gain, la structure à gain étant formée en contact avec la première couche diélectrique en présentant une portion centrale de la structure à gain en regard de la troisième section et une première et une deuxième extrémité en regard de la deuxième et la quatrième section, ainsi, la portion centrale de la structure à gain forme avec la troisième section de guide d'onde un guide d'onde hybride laser, les deuxième et quatrième sections de guide d'onde, et les première et deuxième extrémités de la structure à gain formant une première et une deuxième zone de transition optique d'un mode optique entre le guide d'onde hybride laser et respectivement la première et la cinquième section de guide d'onde, le dispositif photonique étant ainsi formé, lors de ladite formation de la structure, la première partie de l'épaisseur de la troisième section sur laquelle est aménagée la structuration étant séparée de la première couche diélectrique par au moins une deuxième partie de l'épaisseur de la troisième section.

Un tel procédé permet la fabrication d'un dispositif photonique selon l'invention et de bénéficier des avantages qui y sont liés.

L'étape de formation, au moins en partie dans la couche de silicium, du premier guide d'onde et des première à cinquième sections de guide d'onde distinctes du premier guide d'onde peut comprendre les sous étapes suivantes :

- structuration de la couche silicium pour former une deuxième partie d'épaisseur du guide d'onde et des première à cinquième sections de guide d'onde,
- formation à partir d'une couche de silicium complémentaire d'une première partie d'épaisseur du guide d'onde et des première à cinquième sections de guide d'onde.

Il peut en outre être prévu une étape d'amincissement de la première couche diélectrique entre les étapes de suppression du substrat et de formation de la structure à gain.

Un tel amincissement permet d'obtenir une première couche diélectrique présentant une épaisseur adaptée pour bénéficier au mieux des avantages de l'invention.

Après l'étape d'amincissement de la première couche diélectrique, la première couche diélectrique peut présenter une épaisseur inférieure ou égale à 110 nm, l'épaisseur de la première couche diélectrique étant préférentiellement inférieure ou égale à 90 nm, voire à 70 nm, voire à 20 nm.

Lors de l'étape de formation de la structure à gain, la structure à gain peut s'étendre longitudinale selon un axe de propagation optique du dispositif optique et la première et la deuxième extrémité de la structure à gain peuvent présenter, sur au moins une partie de leur épaisseur et selon une direction longitudinale allant en s'éloignant de la portion centrale, une section transversale de largeur décroissante.

Une telle étape de formation de la structure à gain permet la fourniture de la structure à gain particulièrement adaptée à une épaisseur de couche de silicium inférieure à 700 nm, ou inférieure à 500 nm, et pouvant être égale à 400 nm, voire 300 nm.

Lors de l'étape de formation de la structure à gain, la structure à gain peut s'étendre longitudinale selon un axe de propagation optique du dispositif optique et peut comporter une première zone semiconductrice, une deuxième zone semiconductrice, et le milieu à gain, et,

pour chacune de la première et la deuxième extrémité de la structure à gain, la première zone semiconductrice, la deuxième zone semiconductrice et le milieu gain peuvent présenter, sur leur longueur respective, une section transversale de largeur constante.

Une telle étape de formation de la structure à gain permet la fourniture de la structure à gain particulièrement adaptée à une épaisseur de couche de silicium supérieure à 500 nm, et par exemple égale à 700 nm.

**BRÈVE DESCRIPTION DES DESSINS**

La présente invention sera mieux comprise à la lecture de la description d'exemples de réalisation, donnés à titre purement indicatif et nullement limitatif, en faisant référence aux dessins annexés sur lesquels :

- la figure 1 illustre un dispositif photonique de l'art antérieur extraite des travaux de S. Keyvaninia et al. publiés dans la revue scientifique « Optics Letters » en 2013,
- la figure 2 est un graphique également extrait des travaux de S. Keyvaninia *et al.* et représentant la variation de la force de contre réaction d'un réseau de Bragg en fonction de l'épaisseur d'une couche intermédiaire entre le réseau de Bragg et une structure à gain ceci pour différentes épaisseurs de structuration du réseau de Bragg,

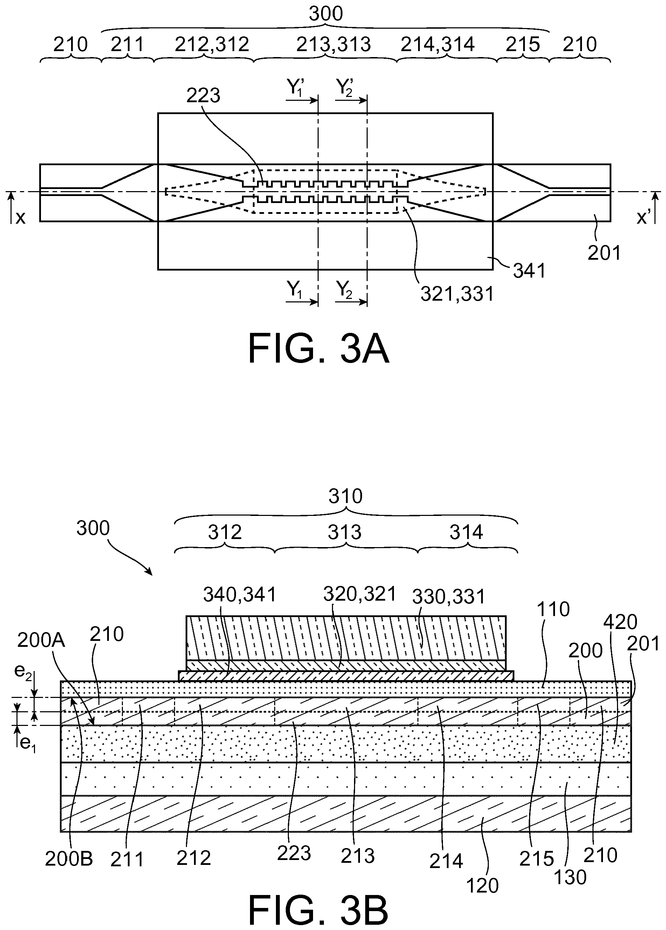

- les figures 3A à 3D illustrent respectivement une vue de dessus, une vue en coupe longitudinale, une vue en coupe transversale selon un plan Y1Y1' et une vue en coupe transversale selon un plan Y2Y2' d'un dispositif photonique selon un premier mode de réalisation de l'invention, les plans de coupe Y1Y1' et Y2Y2' étant montrés sur la figure 3A

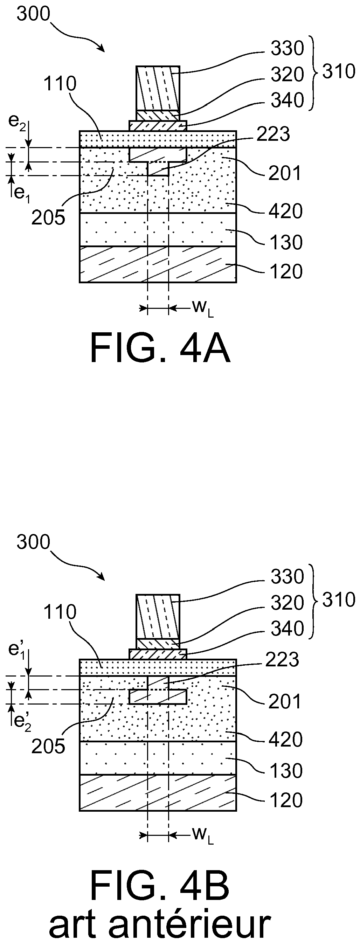

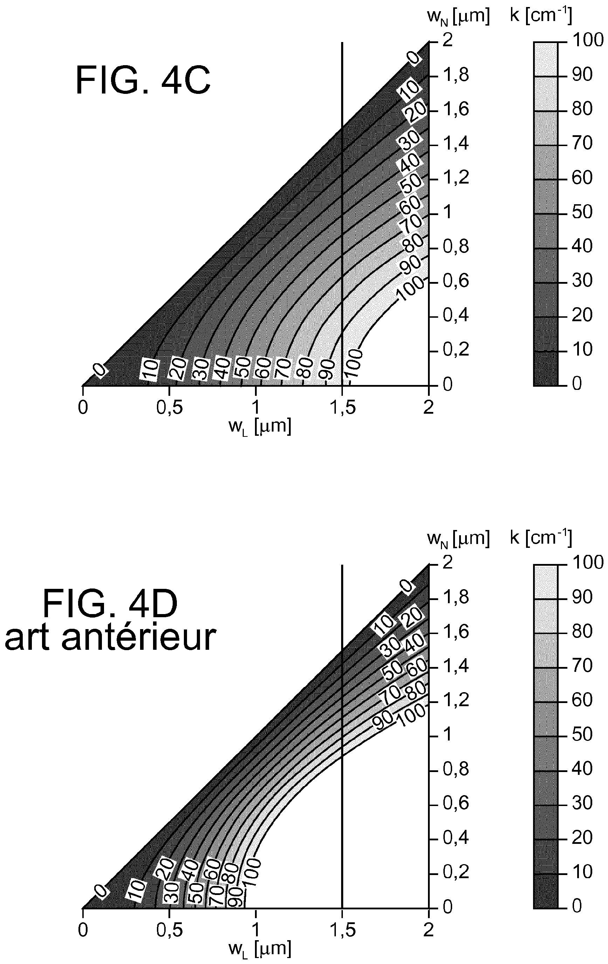

- les figures 4A à 4D illustrent, pour les figures 4A et 4B, des vues en coupes transversales d'un guide d'onde hybride laser de respectivement le dispositif photonique illustrée sur les figures 3A à 3D et un dispositif photonique selon l'art antérieur, l'épaisseur d'une couche de silicium étant identique pour ces deux dispositifs optiques, et les figures 4C et 4D représentant graphiquement la variation de la valeur kappa d'un réseau de Bragg de respectivement le dispositif optique de la figure 4C et celui de la figure 4D, en fonction des largeurs d'arêtes larges et d'arêtes étroites,

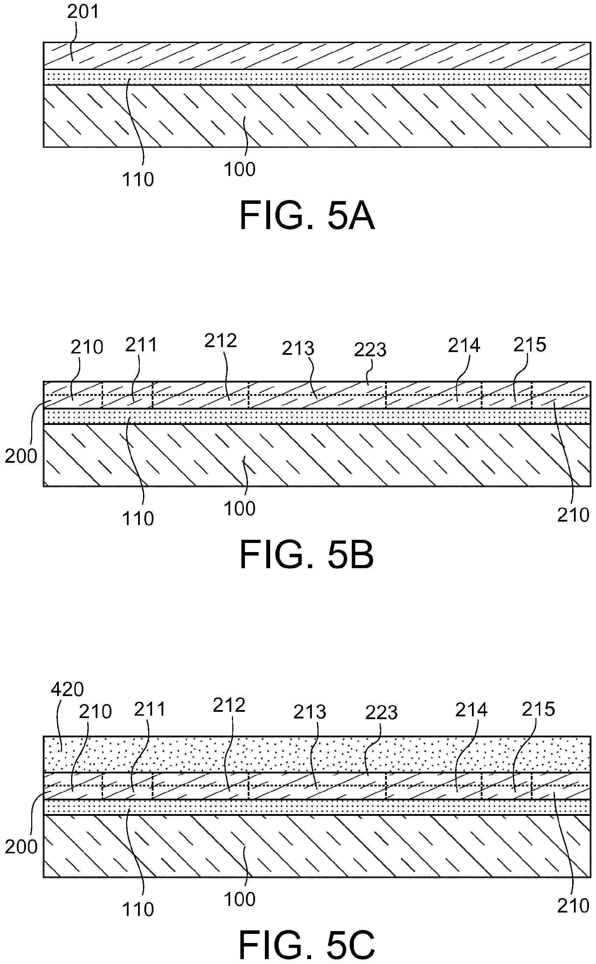

- les figures 5A à 5F illustrent, en vues en coupes longitudinales, les principales étapes de fabrication d'un dispositif photonique tel qu'illustré sur les figures 3A à 3F,

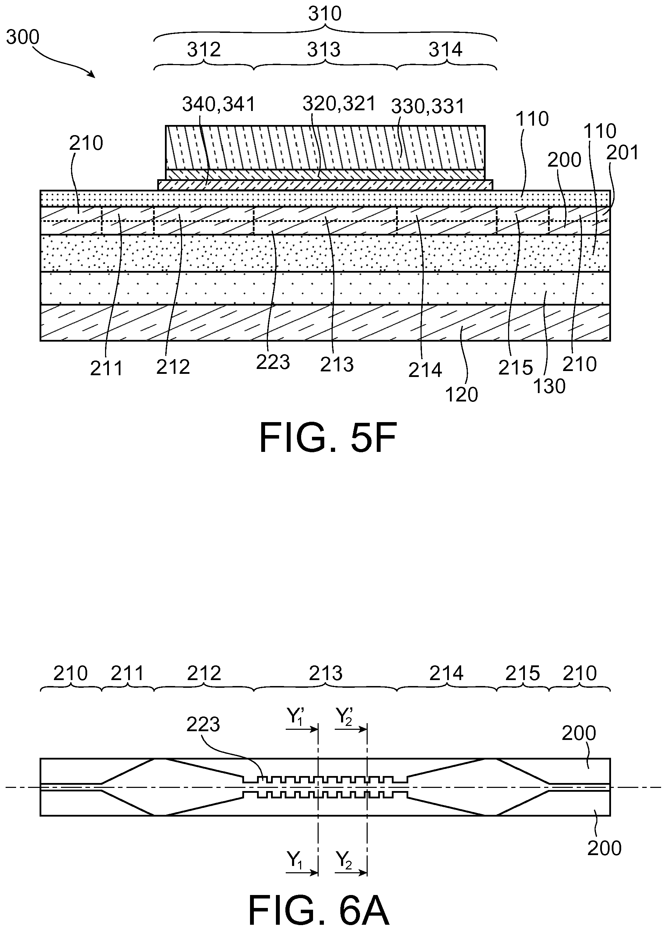

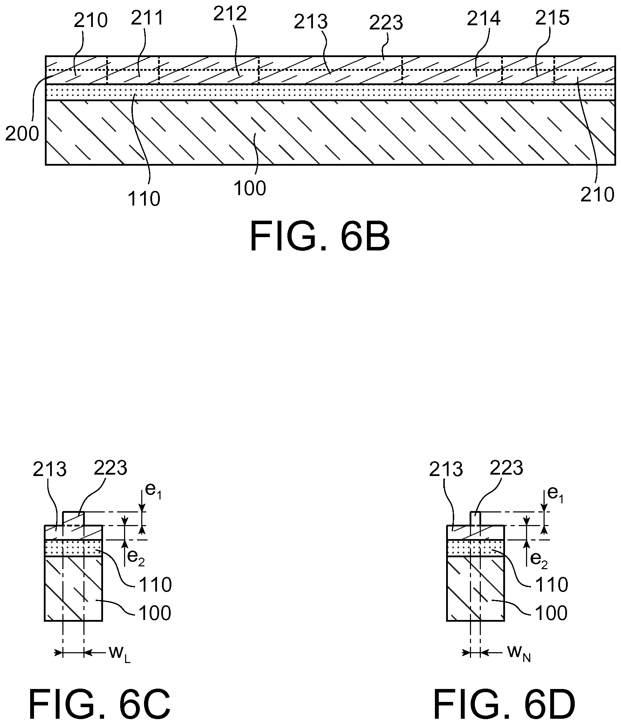

- la figure 6A à 6D illustrent respectivement une vue de dessus, une vue longitudinale, une vue en coupe transversale selon un plan Y1Y1' et une vue en coupe transversale selon un plan Y2Y2' du dispositif intermédiaire figuré sur la figure 4B, les plans de coupe Y1Y1' et Y2Y2' étant montrés sur la figure 6A,

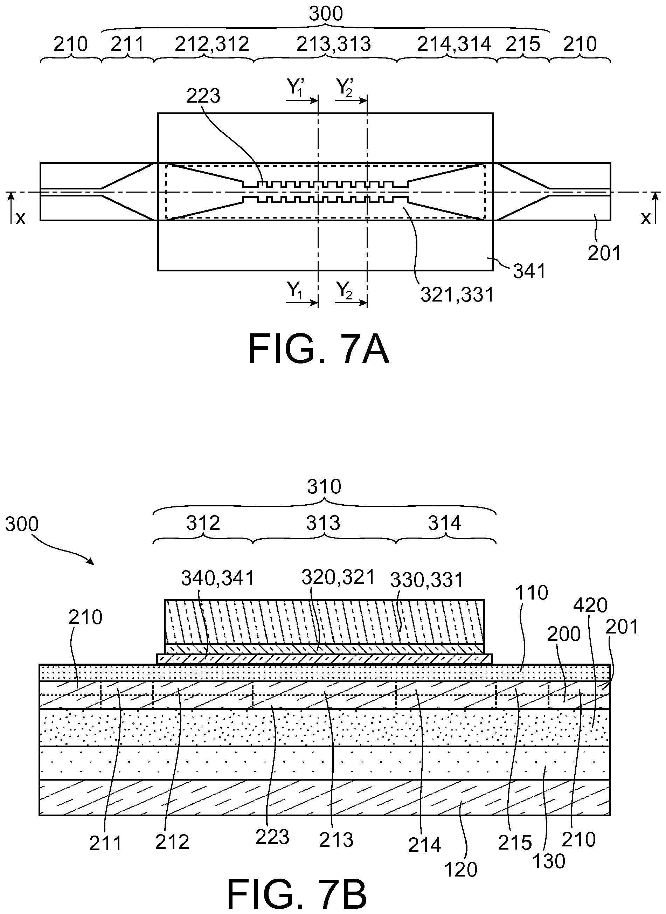

- les figures 7A et 7B illustrent respectivement une vue de dessus et une vue en coupe longitudinale d'un dispositif selon un deuxième mode de réalisation dans lequel une structure à gain du dispositif photonique présente une première et une deuxième extrémité comprenant une section transversale constante,

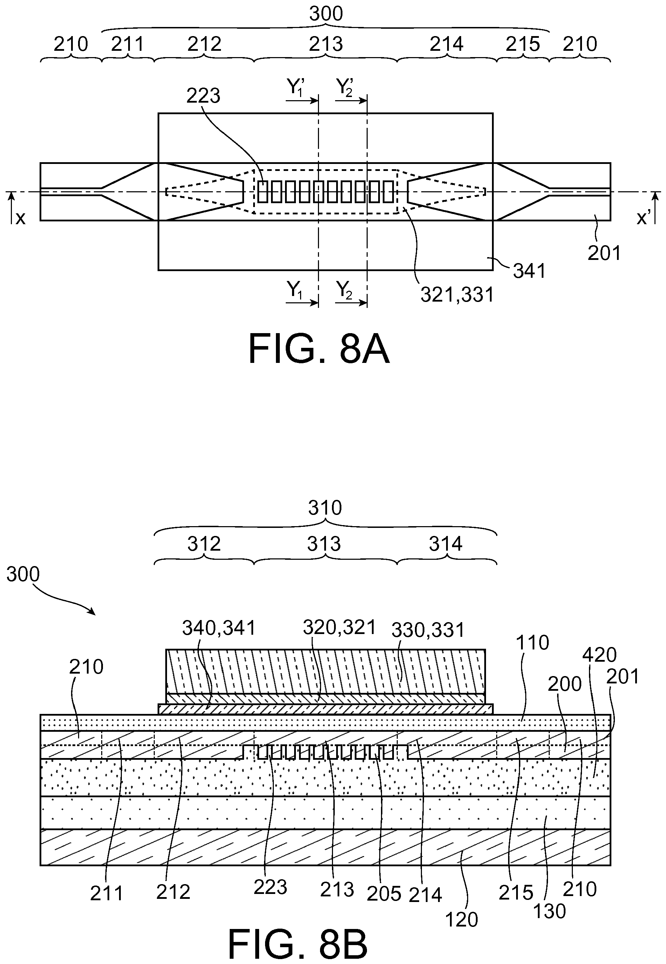

- les figures 8A à 8B illustrent respectivement une vue de dessus, une vue en coupe longitudinale, une vue en coupe transversale selon un plan Y1Y1' et une vue en coupe transversale selon un plan Y2Y2' d'un dispositif photonique selon un troisième mode de réalisation dans lequel une structuration d'une troisième section de guide d'onde présente sur une première épaisseur une alternance entre une section transversale d'une première largeur et une section transversale d'une deuxième largeur de valeur nulle, les plans de coupe Y1Y1 et Y2Y2' étant montrés sur la figure 7A,

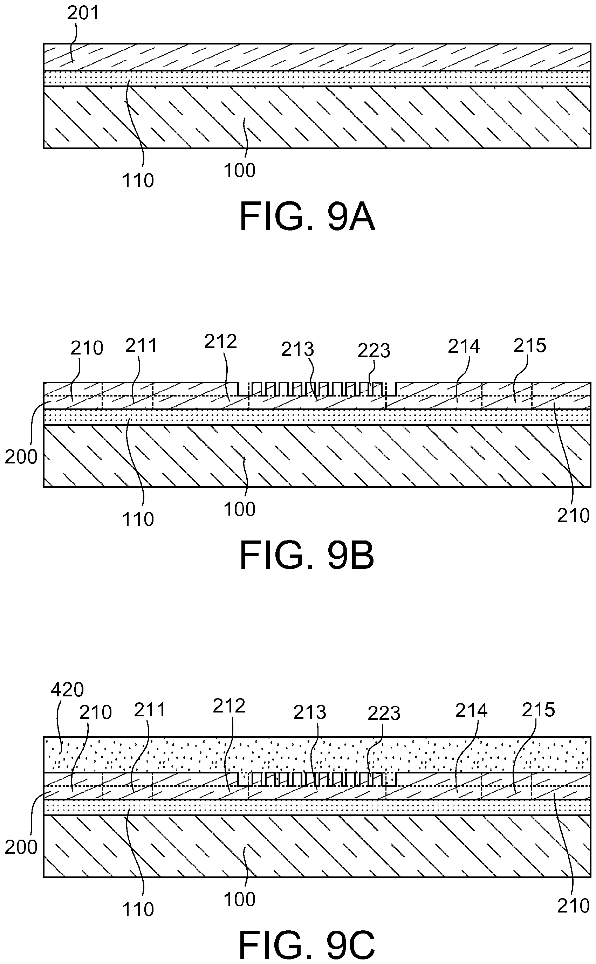

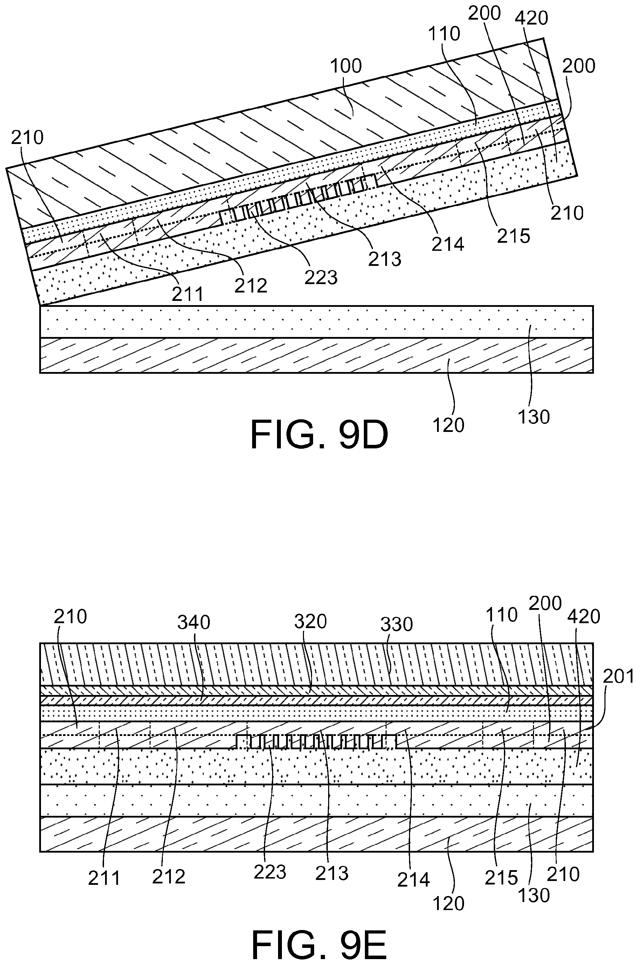

- les figures 9A à 9E illustrent, en vues en coupes longitudinales, les principales étapes de fabrication d'un dispositif photonique tel qu'illustré sur les figures 7A à 7D,

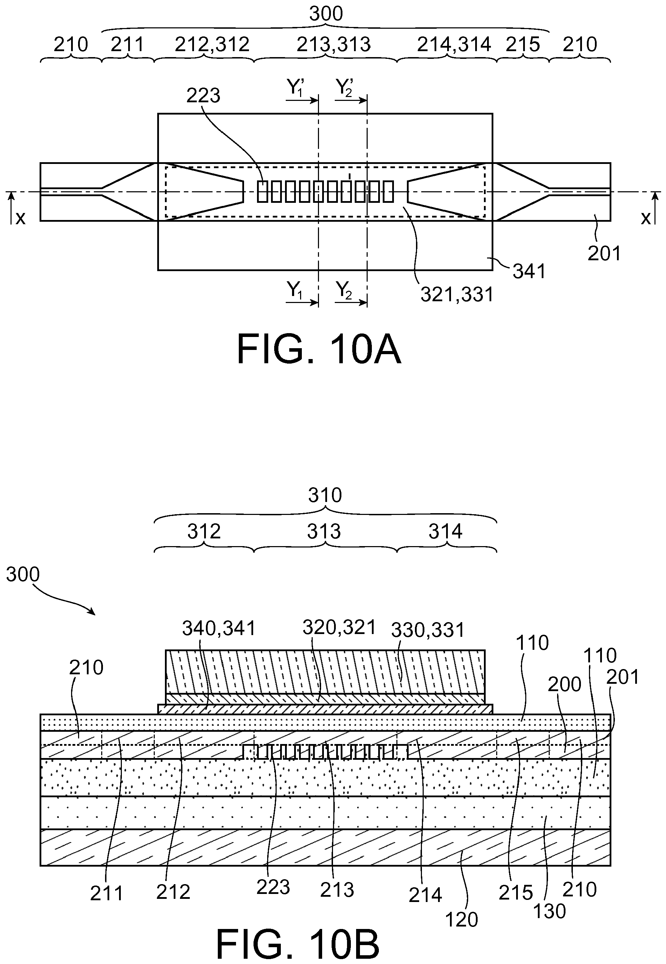

- les figures 10A et 10B illustrent respectivement un vue de dessus et une vue en coupe longitudinale d'un dispositif selon un quatrième mode de réalisation dans lequel une structure à gain du dispositif photonique présente une première et une deuxième extrémité comprenant une section transversale constante et la troisième section de guide d'onde est similaire à celle du dispositif selon les figures 7A à 7D,

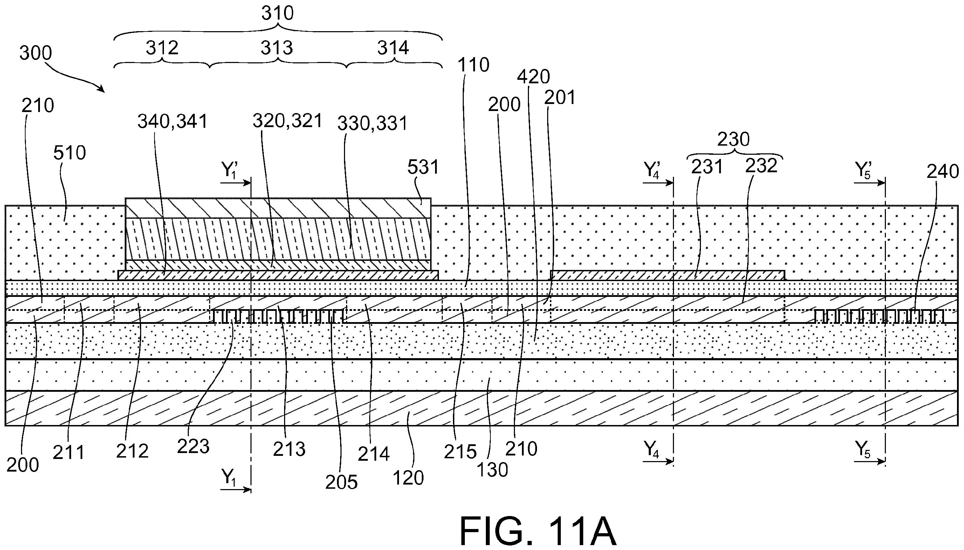

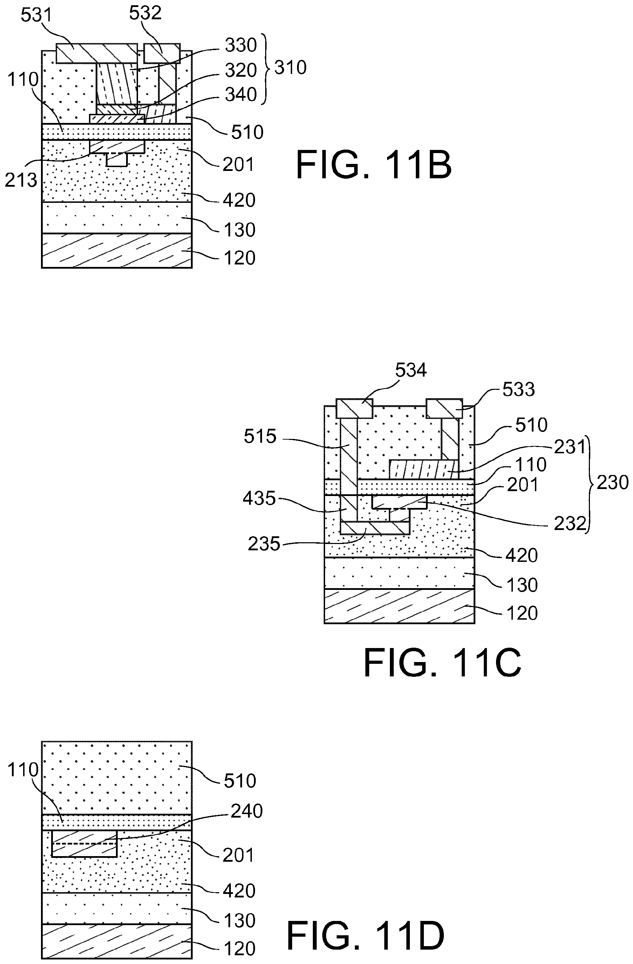

- les figures 11A à 11D illustrent respectivement une vue en coupe longitudinale, une première, deuxième et troisième vue en coupe transversale selon des plans de coupe Y1Y1', Y4Y4' et Y5Y5' d'un dispositif photonique selon un cinquième mode de réalisation de l'invention comprenant un modulateur capacitif, les plans de coupes Y1Y1', Y4Y4' et Y5Y5' étant montrés sur la figure 11A,

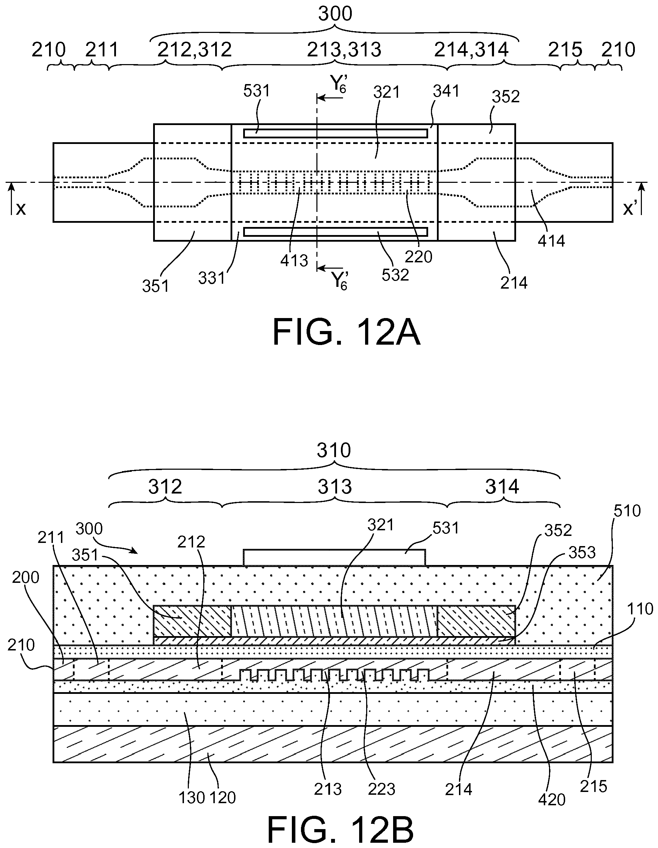

- les figures 12A à 12C illustrent respectivement une vue de dessus, une vue en coupe longitudinale et une vue en coupe transversale selon un plan Y6Y6' d'un dispositif selon un sixième mode de réalisation dans lequel la structure à gain est du type latéral, le plan de coupe Y6Y6' étant montré sur la figure 12A,

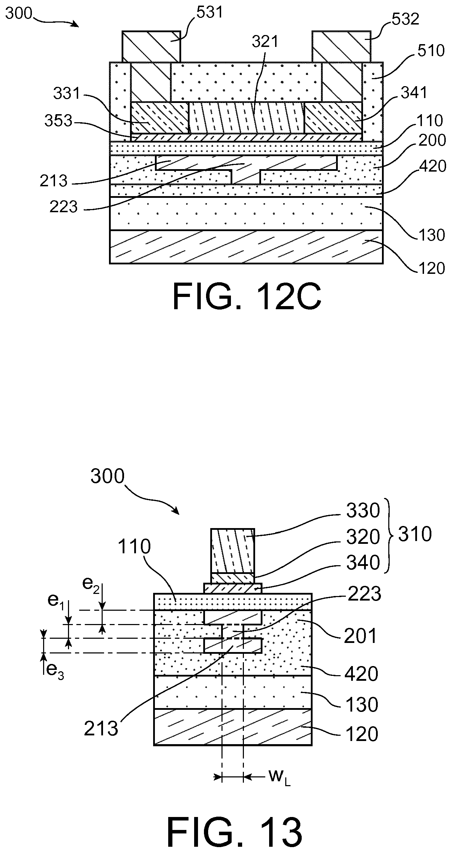

- la figure 13 illustre une vue en coupe transversale au niveau d'une troisième section de guide d'onde d'un dispositif photonique selon un cinquième mode de réalisation dans lequel l'étage de guidage optique comporte une troisième partie d'épaisseur d'une troisième section de guide d'onde.

Des parties identiques, similaires ou équivalentes des différentes figures portent les mêmes références numériques de façon à faciliter le passage d'une figure à l'autre. Ceci est également valable pour l'art antérieur illustré par la figure 1 qui partage, pour les parties similaires, aux différences liées à l'invention près, le même référencement.

Les différentes parties représentées sur les figures ne le sont pas selon une échelle uniforme, pour rendre les figures plus lisibles.

Les différentes possibilités (variantes et modes de réalisation) doivent être comprises comme n'étant pas exclusives les unes des autres et peuvent se combiner entre elles.

On entend ci-dessus et dans le reste de ce document par « coupe transversale » et par « coupe longitudinale » respectivement une coupe selon un plan perpendiculaire à la direction de propagation du champ optique guidé et une coupe selon un plan parallèle à la direction de propagation du champ optique guidé et perpendiculaire à la surface du substrat.

## EXPOSÉ DÉTAILLÉ DE MODES DE RÉALISATION PARTICULIERS

Les figures 3A à 3D représentent respectivement des vues schématiques de dessus, en coupe longitudinale selon le plan XX', et en coupe transversale selon les plans Y1Y1' et Y2Y2' d'un dispositif photonique 1 selon un premier mode de réalisation de l'invention comportant un premier guide d'onde silicium 210 et un laser 300 comprenant un milieu à gain 321 apte à émettre de la lumière, le laser 300 étant connecté optiquement au premier guide d'onde 210.

Le dispositif photonique 1 comporte plus précisément :

- un support 120 comportant une deuxième couche diélectrique 130,

- une couche intermédiaire 420 en contact avec le support 120 par la deuxième couche diélectrique 130, la couche intermédiaire 420 étant constituée d'un matériau diélectrique,

- un étage de guidage optique en contact avec la couche intermédiaire à l'opposé du support 120, l'étage de guidage optique 200 comprenant une partie d'un premier guide d'onde 210, une première à une cinquième section de guide d'onde 211, 212, 213, 214, 215 distinctes du premier guide d'onde 210, la première à la cinquième section 211, 212, 213, 214, 215 de guide d'onde se succédant en étant connectées optiquement deux à deux, et étant connectées au premier guide d'onde 210 par au moins l'une de la première et de la cinquième section de guide d'onde 211, 215, l'étage de guidage optique 200 comprenant en outre un matériau diélectrique de remplissage 205,

- une première couche en matériau diélectrique 110 recouvrant l'étage de guidage optique 200 sur sa première face 200A,

- une structure à gain 310 comportant au moins un milieu à gain 321 apte à émettre de la lumière, la structure à gain 310 présentant une portion centrale en regard de la troisième section de guide d'onde 213 et une première et une deuxième extrémité en regard de la deuxième et la quatrième section de guide d'onde 212, 214, ainsi, la portion centrale de la structure à gain 310 forme avec la troisième section de guide d'onde 213 un guide d'onde hybride laser 313, les deuxième et quatrième section de guide d'onde 212, 214 et les premières et deuxième extrémités de la structure à gain 310 formant une première et une deuxième zone de transition optique 312, 314 d'un mode optique entre le guide d'onde hybride laser 313 et respectivement la première et la cinquième section de guide d'onde 211, 215,

- un premier et un deuxième contact électrique 531, 532, non représentés sur les figure 3A à 3D et qui sont montrés sur la figure 11B, pour contacter électriquement la structure à gain 310, et

- une couche d'encapsulation 510, non illustrée sur les figures 3A à 3D et qui est montrée sur la figure 11B, encapsulant la structure à gain 321 et le premier et deuxième contact électrique 531, 532.

La troisième section de guide d'onde 213 comprend une structuration aménagée uniquement sur une première partie e1 de son épaisseur, ladite structuration formant un réseau de Bragg 223 distribué sous la structure à gain pour former une structure de contre réaction et une cavité résonante comprenant au moins une partie du milieu à gain 321 ceci de manière à former un laser 300 connecté optiquement au premier guide d'onde 210 par au moins l'une de la première et la cinquième section de guide d'onde 211, 215. La première partie e1 de l'épaisseur de la troisième section de guide d'onde 213 sur laquelle est aménagée la structuration est située à distance de la première couche diélectrique 110 et donc de la structure à gain 310. Une telle disposition à distance de la première partie e1 de l'épaisseur de la troisième section de guide d'onde 213 est fournie au moyen d'une deuxième partie e2 de l'épaisseur de la troisième section de guide d'onde 213 disposée entre la première partie e1 de l'épaisseur de la troisième section de guide d'onde 213 et la première couche diélectrique 110. Autrement dit, la deuxième partie e2 d'épaisseur de la troisième section de guide d'onde 213 s'interpose entre la première partie e1 d'épaisseur de la troisième section de guide d'onde 213 et la première couche diélectrique 110.

On notera que, par simplification et comme cela est indiqué par la suite, les figures 3A et 3B n'illustrent pas de défaut quart d'onde dans le réseau de Bragg 223 distribué, ou de réflecteur total d'un côté du laser; l'un et l'autre étant chacun connu de l'homme de l'art pour assurer l'émission du laser du type DFB suivant un unique mode de la cavité. On notera également que pour en faciliter la lecture, la figure 3A a été schématisée pour ne faire figurer que certaines composantes du dispositif photonique. Ainsi, par exemple, le contact électrique 531 et la couche d'encapsulation 510, qui sont notamment présent sur les figures 11A à 11D, n'ont pas été représentés sur les figures 3A à 3D. Dans ce même but, une telle schématisation est également utilisée pour l'ensemble des vues de dessus et des vues en coupe du présent document mises à part les figures 11A à 12C. Ainsi les prises de contact électriques et l'encapsulation dans le matériau 510 ne sont montrées que sur les figures 11A à 12C.

Le support 120 est un support compatible avec les contraintes de la microélectronique et de l'optoélectronique et peut être un support en matériau semiconducteur ou en matériau diélectrique. Dans une application particulière de l'invention, le support peut être un support en silicium cristallin. Selon cette possibilité et selon une variante non illustré les figures 3A et 3B, le support peut également intégrer des composants électroniques de commande et/ ou de lecture complémentaires aux composants optiques, tels que le laser 300 et des composants actifs accommodés dans le premier guide d'onde 210, et des interconnexions électriques reliant lesdits composants électroniques audits composants optiques par le biais des vias et lignes métalliques logés dans le matériau diélectrique de remplissage 205 et la couche intermédiaire 420. De la même façon et selon une variante à ce premier mode de réalisation, le support 120 peut également comporter des via conducteurs électriques traversants participant à la formation des contacts électriques 531, 532, 533, 534 permettant une connexion électrique de ces mêmes composants optiques à un deuxième substrat, le deuxième substrat dit de commande, intégrant lesdits composants électroniques de commande et/ou de lecture complémentaires aux composants optiques.

Comme illustré sur la figure 3B, le support 120 comporte une deuxième couche diélectrique 130.

La deuxième couche diélectrique 130 est préférentiellement adaptée pour permettre un assemblage par collage par adhésion moléculaire de la couche intermédiaire 420 sur le support 120. Ainsi, la deuxième couche diélectrique 130 présente à cet effet une deuxième surface de collage plane. Dans l'application particulière de l'invention, la deuxième couche diélectrique 130 est réalisée en dioxyde de silicium $SiO_2$.

La couche intermédiaire 420 comporte une première face, formant préférentiellement une première surface de collage plane, par laquelle elle est en contact avec la deuxième couche diélectrique 130, et une deuxième face opposée à la première face. La couche intermédiaire 420 comprend un matériau diélectrique de tel manière que les deuxième et quatrième sections de guide d'onde 212, 214 sont en contact avec la couche intermédiaire 420 sur une partie de la couche intermédiaire 420 qui est constituée uniquement de matériaux diélectriques. La couche intermédiaire est également en contact avec la troisième section de guide d'onde 213.

On notera qu'avec une telle configuration selon l'invention, la couche intermédiaire 420 ne comporte pas, en regard de chacune de la deuxième et de la quatrième section de guide d'onde 212, 214, de surépaisseur d'un quelconque type et que la troisième section de guide d'onde 213 n'est pas en regard d'un quelconque espace délimité par de telles surépaisseurs.

Le matériau diélectrique de la couche diélectrique est préférentiellement du dioxyde de silicium $SiO_2$. Selon une possibilité de l'invention, non illustrée sur les figures 3A à 3B, la couche intermédiaire peut comporter plusieurs matériaux diélectriques sous la forme de plusieurs sous-couches.

La couche intermédiaire 420 est en contact par sa deuxième face avec l'étage de guidage optique 200. L'étage de guidage optique 200 comporte une première face 200A par laquelle elle est en contact avec la couche intermédiaire 420 et une deuxième face 200B opposée à sa première face 200A.

Dans ce premier mode de réalisation, l'étage de guidage optique 200 est formé à partir d'une couche de silicium 201, illustrée sur la figure 5A issue d'un substrat du type couche de silicium sur une couche diélectrique 110. Ce type de substrat est plus connu sous la dénomination anglaise de « silicon on insulator » et le sigle anglais associé SOI qui veulent dire 'silicium sur isolant'.

Dans une configuration particulière de l'invention, la couche de silicium 201 est une couche de silicium superficielle issue d'un substrat silicium sur isolant, connu sous le sigle anglais 'SOI' pour Silicon on Insulator. Une telle couche de silicium 201 issue d'un substrat du type substrat SOI offre entre autre avantage de posséder une bonne qualité cristalline et une épaisseur contrôlée, permettant de fournir un premier guide d'onde 210 et des sections de guide d'onde 211, 212, 213, 214, 215 présentant des pertes optiques faibles. Dans une configuration particulière de l'invention, la couche diélectrique 110 est en dioxyde de silicium SiO$_2$, et est connue sous la dénomination anglaise « Buried oxide » et le sigle BOX pour oxyde enterré. L'utilisation d'un tel substrat SOI présente également comme avantage d'autoriser la fourniture d'une première couche diélectrique 110 d'épaisseur et de planéité contrôlées par l'intermédiaire de la couche BOX.

En variante de cette configuration utilisant une seule couche de silicium 201 formée par une couche silicium superficielle d'un substrat SOI sur et une couche diélectrique 110 issue du BOX du même substrat SOI, il est également envisageable d'utiliser une première couche de silicium, issue d'un substrat SOI sur une couche diélectrique 110, en association avec une deuxième couche de silicium en contact direct avec ladite première couche de silicium, ou en contact avec ladite première couche de silicium par le biais d'une couche intermédiaire en matériau diélectrique. Cette deuxième couche de silicium peut être soit déposée par un procédé de dépôt, soit être une couche reportée par collage moléculaire.

Dans l'application particulière de l'invention, la couche de silicium 201 présente une épaisseur de 300 nm ou de 500 nm.

Le premier guide d'onde 210 et les première à cinquième sections de guide d'onde 211, 212, 213, 214, 215 sont obtenus, dans ce premier mode de réalisation, par gravure de la couche de silicium 201.

Bien entendu, comme cela est illustré à la suite de ce document, notamment en lien avec les figures 11A à 11D, le premier guide d'onde 210 peut également accommoder d'autres composants, qu'ils soient optiques, tels qu'un modulateur optique et un réseau de couplage surfacique, non illustrés sur les figures 3A et 3B, et/ou électroniques, conformément à l'enseignement de Jason S. Orcutt et ses coauteurs dans l'article 'Open foundry platform for high-performance electronic-photonic intégration' publié en 2012 dans la revue scientifique « Optics express », volume 20, numéro 11 page 12222-12232.

En ce qui concerne le ou les composants optiques, ceux-ci peuvent être des composants actifs, tels que des modulateurs, des photodétecteurs et des déphaseurs, ou des composants passifs tels que des multiplexeurs en longueurs d'onde, des réseaux de couplage surfacique et des coupleurs par la tranche de la puce. A cet effet, pour permettre une connexion électrique des composants optiques actifs et/ou des éventuels composants électronique, le dispositif photonique 1 peut comprendre en outre des vias métalliques logés dans le matériau diélectrique 205 et la couche intermédiaire 420 et/ou dans une couche d'encapsulation de la structure à gain 310 et, dans la première couche diélectrique. De tels vias métalliques sont décrits plus avant dans la suite de ce document en relation avec les figures 11A à 11D.

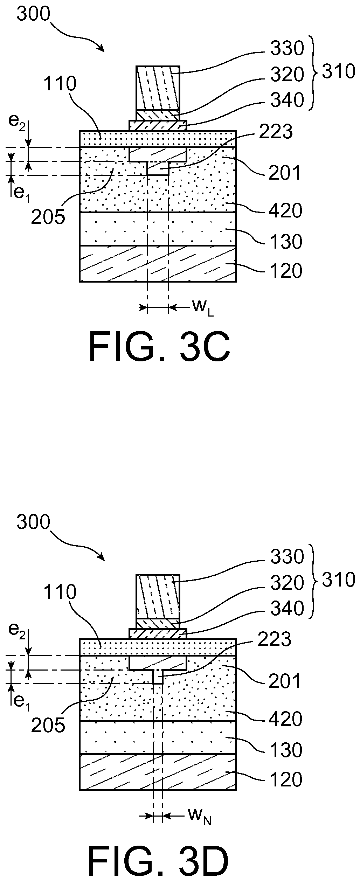

Dans l'application pratique de l'invention, Comme illustré sur les figures 3C et 3D représentant des vues en coupe de la troisième section de guide d'onde 213 selon les plans de coupe Y1Y1' et Y2Y2', chacun du premier guide d'onde 210 et de la première à la cinquième guide d'onde 211, 212, 213, 214, 215 comporte, sur une deuxième partie e2 de leur épaisseur comportant la deuxième face 200B de l'étage de guidage optique 200, une embase et, sur une première partie e1 de l'épaisseur, comportant la première face 200A de l'étage de guidage optique 200, une portion, dite arête, présentant une section transversale réduite vis-à-vis de l'embase.

Bien entendu, une telle forme du premier guide d'onde 210 et des sections de guide d'onde 211, 212, 213, 214, 215 est purement illustrative de l'application pratique de l'invention et d'autres formes sont envisageables sans qu'on sorte du cadre de l'invention. Ainsi et par exemple, le premier guide d'onde 210 peut également présenter une section transversale constante.

On notera également que, selon la variante dans laquelle l'étage de guidage optique 200 est obtenu au moyen d'une première couche de silicium issue d'un substrat du type couche de silicium sur une couche diélectrique 110 en association avec une deuxième couche de silicium en contact avec ladite première couche de silicium, il est envisageable que l'embase soit fournie par la première couche de silicium 201 et que l'arête soit fournie par la deuxième couche de silicium. Selon cette possibilité, l'arête peut être fournie :

- soit par gravure de ladite deuxième couche de silicium,
- soit par dépôt de la deuxième couche de silicium sur ladite première couche de silicium sous la forme d'arêtes en contact avec l'embase préalablement gravée dans la première couche de silicium.

Le guide d'onde 210 est connecté optiquement à la première section de guide d'onde 211. Comme illustré sur les figures 3A et 3B, dans ce premier mode de réalisation de l'invention, le premier guide d'onde 210, comme la première à la cinquième section de guide d'onde 211, 212, 213, 214, 215, sont formées dans la couche de silicium 201 dans l'intégralité de l'épaisseur de celle-ci. Bien entendu, en variante, l'une ou plusieurs parmi le premier guide d'onde 210 et la première à la cinquième section de guide d'onde 211, 212, 213, 214, 215 peuvent être formées dans une partie de l'épaisseur de la couche de silicium 201, et ainsi présenter des épaisseurs différentes.

Les première à cinquième sections de guide d'onde 211, 212, 213, 214, 215 se succédant, la première section de guide d'onde 211 est donc connectée optiquement à la deuxième section de guide d'onde 212 étant elle-même connectée optiquement à la troisième section de guide d'onde 213, et ainsi de suite. De cette manière, les première à la cinquième sections de guide d'onde 211, 212, 213, 214, 215 sont connectées optiquement au premier guide d'onde 210 par la première section de guide d'onde 211.

Comme illustré schématiquement sur la figure 3A, La deuxième et la quatrième section de guide d'onde 212, 214 présentent, chacune, selon une direction allant de l'intérieur de la structure à gain 310 vers l'extérieur de la structure à gain 310, et dans une première partie e1 de leur épaisseur :

- sur une première partie de sa longueur une section transversale croissante,
- sur une deuxième partie de sa longueur, une section transversale constante, cette deuxième partie étant optionnelle.

La première et la cinquième section de guide d'onde 211, 215 présentent, chacune, selon une direction allant de l'intérieur de la structure à gain 310 vers l'extérieur de la structure à gain 310, et dans une première partie e1 de leur épaisseur une section transversale dont la largeur est décroissante.

On entend ci-dessus et dans le reste de ce document par section transversale d'un guide d'onde, la section du guide d'onde suivant un plan perpendiculaire à la direction de propagation de la lumière dans le guide, et perpendiculaire au support 120.

Selon une possibilité de l'application particulière de l'invention montrée sur la figure 3A, chacune des première à la cinquième sections de guide d'onde 211, 212, 213, 214, 215, de la même façon que le premier guide d'onde 210, présentent une section transversale de largeur constante formant une embase dans une deuxième partie e2 de leur épaisseur comportant la deuxième face 200B de l'étage de guidage optique 200.

Bien entendu d'autres configurations de la première, deuxième, quatrième, et cinquième sections de guide d'onde 211, 212, 214, 215 sont également envisageables sans que l'on sorte du cadre de l'invention.

La troisième section de guide d'onde 213 comporte la structure de contre réaction optique sous la forme d'un réseau de Bragg 223 distribué sous la partie centrale de la structure à gain 310. Plus précisément, comme illustré sur la vue dessus de la figure 3A, la structure de contre réaction optique est un réseau de Bragg 223 distribué à « corrugations latérales », c'est-à-dire que la variation d'indice optique du réseau de Bragg est fournie par une variation de la largeur transversale du guide d'onde.

Ainsi, selon cette possibilité, la troisième section de guide d'onde 213 s'étend longitudinalement le long d'un axe de propagation optique du dispositif optique 1 et la structuration de la troisième section de guide d'onde 213 consiste en une alternance entre une portion de section transversale d'une première largeur WL, dite arête larges et une portion d'une section transversale d'une seconde largeur WN, dite arête étroite, les valeurs WN et WL respectant les inégalités suivantes : $0 < WN < WL$. Avec une telle structure de contre réaction, le laser est, conformément à l'invention, un laser du type laser à rétroaction répartie également connu sous la dénomination anglaise « Distributed FeedBack laser » et le sigle correspondant laser DFB.

Dans le réseau de Bragg 223 distribué selon l'invention, la période de répétition des portions d'arêtes d'une même largeur (arêtes larges ou étroites), conformément au principe d'un réseau de Bragg, est sensiblement de $\lambda/2n_{eff}$, $\lambda$ étant la longueur d'onde d'émission du laser 300 et $n_{eff}$ l'indice effectif moyen du mode guidé par le guide d'onde hybride 313. Avec une telle configuration, le réseau de Bragg 223 distribué est un réseau de Bragg à « corrugations latérales » partiellement gravées dans l'épaisseur de la troisième section de guide d'onde 213.

Dans l'application pratique de l'invention et comme illustré sur les vues en coupe selon plans Y1Y1' et Y2Y2' montrées sur les figures 3C et 3D, la variation de largeur transversale pour le réseau de Bragg 223 distribué est réalisée sur une première partie e1 de l'épaisseur de la troisième section de guide d'onde 213 qui est à distance de la première couche diélectrique.

Suivant la configuration décrite, la troisième section de guide d'onde 213 comprend, de la même façon que les première, deuxième, quatrième et cinquième sections de guide d'onde 211, 212, 214, 215, une embase sur une deuxième partie e2 de son épaisseur. L'embase présente une largeur transversale constante et une épaisseur e2 par exemple égale à 150 nm.

Autrement dit, la troisième section de guide d'onde 213 présente, sur la première partie e1 de son épaisseur, celle correspondant à l'arête, qui est la plus éloignée de la structure à gain 310, une alternance entre une section transversale d'une première largeur WL et une section transversale d'une seconde largeur WN.

On notera que selon l'invention, la valeur d'épaisseur de l'embase e2 peut être ajustée pour modifier la force de contre réaction du réseau de Bragg 223 distribué, comme c'est déjà le cas dans les structurations de l'état de l'art.

Selon une possibilité avantageuse de l'invention non illustrée sur les figures 3A à 3D, le réseau de Bragg distribué peut comporter un défaut de phase de type quart d'onde afin d'optimiser une sélectivité de la cavité résonante.

En variante de cette possibilité et afin d'optimiser la sélectivité de la cavité résonante, la première ou la cinquième section de guide d'onde 211, 215 peut accommoder un réflecteur sensiblement total, le réflecteur total pouvant être sélectionné parmi les réflecteurs de type Sagnac, les réseaux de Bragg distribués, les miroirs du type facette avec traitement haute réflectivité. Dans le même but et en variante, il est également envisageable que l'une parmi la deuxième section de guide d'onde 212 et la quatrième section de guide d'onde 214 accommode un réflecteur sensiblement total, le réflecteur total pouvant être sélectionné parmi les réflecteurs de type réseaux de Bragg distribués, les miroirs du type facette avec traitement haute réflectivité.

Un matériau diélectrique de remplissage 205 remplit les parties de la couche de silicium 201 évidées lors de la formation du premier guide d'onde et des première à cinquième sections de guide d'onde, ce matériau diélectrique de remplissage pouvant être, par exemple, identique à celui de la couche intermédiaire 420.

L'étage de guidage optique présente sa deuxième face 200B en contact avec une première face de la première couche diélectrique 110. La première couche diélectrique 110 comporte, outre sa première face, une deuxième face, opposée à la première face, par laquelle elle est en contact avec la structure à gain 310

La première couche diélectrique 110 est une couche diélectrique issue d'un substrat du type silicium sur isolant ou SOI, celle-ci étant fournie par l'isolant sur lequel est disposée la couche de silicium 201. Selon l'application pratique de l'invention la première couche diélectrique 110 est une couche de dioxyde de silicium SiO$_2$ dont l'épaisseur est inférieure à 100 nm. L'épaisseur de la première couche diélectrique 110 est ainsi préférentiellement inférieure ou égale à 90 nm, voire à 70 nm. Par exemple, la première couche diélectrique peut présenter une épaisseur de 15 ou de 50 nm.

Selon une possibilité optionnelle de l'application pratique de l'invention correspondant à ce premier mode de réalisation, la première couche diélectrique 110 peut être une couche d'isolant d'un substrat du type silicium sur isolant dont l'épaisseur a été amincie partiellement.

En variante à ce premier mode de réalisation, la première couche diélectrique 110 peut être une couche de matériau diélectrique déposée ou reportée en contact sur la couche silicium 201, la couche d'isolant d'un substrat du type silicium sur isolant à l'origine de la couche de silicium 201 ayant été totalement gravée. Selon une autre variante de l'invention non illustrée, la première couche diélectrique 110, peut comporter une première sous-couche correspondant à une couche d'isolant d'un substrat du type silicium sur isolant à l'origine de la couche de silicium 201, ce première couche ayant été préférentiellement amincie et une deuxième sous-couche déposée ou reportée sur la première sous-couche. Cette deuxième sous-couche peut être réalisée du même matériau diélectrique que la première sous couche de la première couche diélectrique 110 ou d'un autre matériau diélectrique.

La première couche diélectrique 110 est en contact avec la structure à gain 310 par sa deuxième face.

Comme illustré sur la figure 3B, la structure à gain 310 comporte :

- une première zone semiconductrice 341 d'un premier type de conductivité formée dans une première couche semiconductrice 340,
- le milieu à gain 321 formé dans une deuxième couche semiconductrice 320,
- une troisième zone semiconductrice 331 d'un deuxième type de conductivité opposé au premier type de conductivité et formée dans une troisième couche semiconductrice 330.

Selon une configuration usuelle de l'invention, la première, la troisième et la deuxième couche semiconductrice 340, 330, 320 et donc les première et troisième zones semiconductrices 341, 331 et le milieu à gain 321, sont tous trois réalisés en matériaux semiconducteurs à gap direct tels que des semiconducteurs III-V. Ainsi, La première, et la troisième couche semiconductrice 340, 330 sont préférentiellement réalisées dans des semiconducteurs III-V, tels que du phosphure d'indium InP ou du l'arséniure de gallium GaAs, tandis que la deuxième couche semiconductrice 320 est préférentiellement formée par un empilement de composés binaires, ternaires quaternaires de matériaux semiconducteur III-V.

Le premier et le deuxième type de conductivité sont choisis parmi le type de conductivité dans lequel les porteurs majoritaires sont des électrons, c'est-à-dire celui fourni par un dopage dit N, et le type de conductivité dans lequel les porteurs majoritaires sont des trous, c'est-à-dire celui fourni par un dopage dit P.

Les figures 3B, 3C et 3D illustrent ainsi plus précisément l'agencement des première, et troisième zones semiconductrices 341, 331 et du milieu à gain 321 afin de former la structure à gain 310. La première zone semiconductrice 341 présente une première face en contact avec la première couche diélectrique 110 et une deuxième face opposée à la première face par laquelle elle est en contact avec le milieu à gain 321. Le milieu à gain 321 comporte une première face par laquelle il est en contact avec la première zone semiconductrice 341 et une seconde face opposée à la première face par laquelle il est en contact avec la troisième zone semiconductrice 331.

La première zone semiconductrice 341 présente une largeur supérieure à celle du milieu à gain 321 et de la troisième zone semiconductrice 331 afin d'autoriser une prise de contact au moyen du deuxième contact électrique, non illustré sur les figures 3A à 3D.

Le milieu à gain 321 et la troisième zone semiconductrice 331 présente une largeur identique. La première zone semiconductrice présente sur sa deuxième face une partie en contact avec un premier contact électrique non illustré.

La structure à gain 310 est agencée, comme illustré sur la figure 3B, en contact avec la deuxième face de la première couche diélectrique 110 de telle manière que la structure à gain 310 présente une portion centrale en regard de la troisième section de guide d'onde 213. Avec une telle configuration :

- la portion centrale de la structure à gain 310 forme avec la troisième section de guide d'onde 213 un guide d'onde hybride laser,
- la deuxième section de guide d'onde 212 et la première extrémité de la structure à gain 310 forment une première zone de transition optique 312 du mode optique entre le guide d'onde hybride optique 313 et la première section de guide d'onde 211,

- la quatrième section de guide d'onde 214 et la deuxième extrémité de la structure à gain 310 forment une deuxième zone de transition optique 314 du mode optique entre le guide d'onde hybride optique 313 et la cinquième section de guide d'onde 215.

Ainsi, la structure à gain 310 est, à l'exception de ses première et deuxième extrémités, en regard de la troisième section de guide d'onde 213. Avec un tel agencement, le milieu à gain 321 est couplé optiquement avec la structure de contre réaction optique permettant de former une cavité résonante comprenant le milieu à gain 321.

Dans ce premier mode de réalisation, comme illustré sur la figure 3A, chacune de la première et la deuxième extrémité de la structure à gain 310 présente, sur une partie de son épaisseur et selon une direction longitudinale allant en s'éloignant de la portion centrale, une section transversale dont la largeur décroit. Plus précisément, chacun du milieu à gain 321 et de la troisième zone semiconductrice 331 présente, au niveau de la première et la deuxième extrémité de la structure à gain, une section transversale dont la largeur est décroissante selon une direction longitudinale allant en s'éloignant de la portion centrale. Autrement dit, chacun du milieu à gain 321 et de la troisième zone semiconductrice 331 présente une première et une deuxième extrémité effilées. La première zone semiconductrice 341 présente, quant à elle, une section transversale constante sur l'ensemble de sa longueur.

Une telle variation de section aux deux extrémités, et sur une partie de l'épaisseur, de la structure à gain 310 est particulièrement adaptées à une épaisseur de couche de silicium 201 inférieure à 700 nm, ou inférieure à 500 nm, et pouvant être égale à 400 nm, voire 300 nm.

Un tel dispositif photonique 1 est particulièrement avantageux vis-à-vis de l'art antérieur notamment en ce qui concerne la possibilité d'obtenir des valeurs kappa de force de contre réaction du réseau de Bragg 223 compatible avec une faible épaisseur de la première couche diélectrique 110.

Afin d'illustré un tel avantage, les figures 4A et 4B montrent, une vue en coupe transversale du guide d'onde hybride laser 313 d'un dispositif photonique 1 selon respectivement le premier mode de réalisation de l'invention, qui est donc conforme à l'invention, et selon l'art antérieur.

La configuration commune de ces deux dispositifs photonique 1 est la suivante :

- une couche de silicium 201 d'épaisseur égale à 300 nm,
- une première couche diélectrique 110, en dioxyde de silicium SiO$_2$, d'épaisseur égale à 20 nm,
- une première épaisseur $e_1$, $e_1$', c'est-à-dire de l'arête de la troisième section de guide d'onde 213, égale à 150 nm,
- une deuxième épaisseur $e_2$, $e_2$', c'est-à-dire de l'embase de la troisième section de guide d'onde 213, égale à 150 nm.

Ainsi, le dispositif photonique 1 selon le premier mode de réalisation illustré sur la figure 4A et le dispositif photonique 1 selon l'art antérieur illustré sur la figure 4B se distinguent uniquement par la disposition de l'embase, celle-ci étant en contact avec la première couche diélectrique 110 pour le dispositif photonique 1 selon l'invention et en contact avec la couche intermédiaire 420 pour le dispositif photonique 1 selon l'art antérieur.

Les inventeurs ont calculées la variation de la force de contre réaction pour le réseau de Bragg du dispositif photonique 1 selon l'invention conforme à la figure 4A et pour le dispositif photonique 1 selon l'art antérieur conforme à la figure 4B, ceci en fonction de la première largeur WL et de la deuxième largeur WN. Les figures 4C et 4D illustrent les résultats de ces calculs pour respectivement le dispositif photonique 1 illustré sur la figure 4A et le dispositif photonique 1 illustré sur la figure 4B, avec en abscisse la première largeur WL et en ordonné la deuxième largeur WN, la valeur de force de contre réaction kappa étant représentée sous la forme de contours isovaleurs dans les graphiques de la figure 4C et 4D.

On peut ainsi observer sur les figures 4D et 4C que, pour une première largeur WL de 1.5 $\mu$m, adaptée pour une couche de silicium 201 de 300 nm, la valeur de force de contre réaction varie entre 0 à une valeur dépassant très largement les 100 cm$^{-1}$ pour le dispositif photonique de l'art antérieur alors que le dispositif photonique selon l'invention permet d'obtenir une force de réaction réduite ne dépassant pas les 100 cm$^{-1}$. Ainsi, comme le montre ces valeurs, l'invention permet d'obtenir une force de contre réaction satisfaisante pour la formation de lasers de longueur de zone active centrale supérieure ou égale à 50 $\mu$m.

Les figures 5A à 5E illustrent les principales étapes de fabrication d'un procédé de fabrication d'un dispositif photonique 1 selon l'invention. Un tel procédé de fabrication, de la même façon que l'ensemble des procédés décrits dans le présent document, est particulièrement adapté pour la mise en œuvre de ses étapes de fabrication en parallèle pour permettre la formation simultanée d'une pluralité de dispositifs photoniques 1 sur un même support 120. Avec une telle mise en œuvre en parallèle, un tel procédé de fabrication de dispositifs photoniques est dit collectif.

Un tel procédé de fabrication comporte les étapes suivantes :

- fourniture d'un substrat 100 associé avec au moins une première couche de silicium 201 sur une première couche diélectrique 110, comme illustré sur la figure 5A,
- structuration de la couche de silicium 201 pour former le premier guide d'onde 210 et les première à cinquième sections de guide d'onde 211, 212, 213, 214, 215 distinctes du premier guide d'onde 210, la première à la cinquième section de guide d'onde 211, 212, 213, 214, 215 se succédant et étant connectées optiquement deux à deux, et étant connectées optiquement au premier guide d'onde 210 par au moins l'une de la première et la cinquième section de guide d'onde 211, 215, la troisième section 213 comprenant une structuration aménagée uniquement sur une première partie e1 de son épaisseur, ladite structuration formant un réseau de Bragg 223 distribué, comme figuré sur la figure 4B et les figures 6A à 6D,

- enterrement du premier guide d'onde 210 et des première à cinquième section de guide d'onde 211, 212, 213, 214, 215 par au moins un matériau diélectrique 205 et planarisation dudit matériau diélectrique afin de former un étage de guidage optique 200, comprenant le premier guide d'onde 210, les première à cinquième section de guide d'onde 211, 212, 213, 214, 215 et le matériau diélectrique 205, et une couche intermédiaire 420 en contact avec ledit étage de guidage optique 200, la troisième section de guide d'onde 213 étant en contact avec la couche intermédiaire 420, les deuxième et quatrième sections de guide d'onde 212, 214 étant en contact avec la couche intermédiaire 420 sur une partie de la couche intermédiaire qui est constituée uniquement de matériaux diélectrique, un ensemble substrat 100/ première couche diélectrique 110/ étage de guidage optique 200/ couche intermédiaire 420 étant ainsi formé, comme illustré sur la figure 5C,

- fourniture d'un support 120 comportant une deuxième couche diélectrique 130,

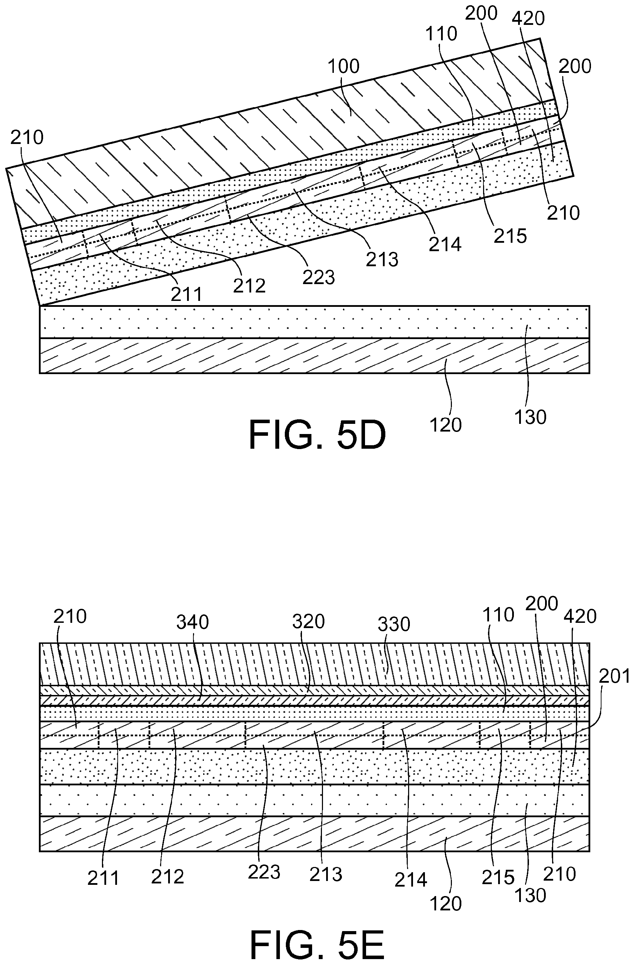

- assemblage de l'ensemble substrat 100/ première couche diélectrique 110/ étage de guidage optique 200/ couche intermédiaire 420 sur le support 120, l'assemblage étant réalisé par collage moléculaire de la couche intermédiaire sur le support 120, comme figuré sur la figure 5D,

- suppression du substrat 100,

- formation des première, deuxième et troisième couches semiconductrices 340, 320, 330, comme illustré sur la figure 5E,

- gravure partielle des première, deuxième et troisième couches semiconductrices 340, 320, 330 de manière à former la structure à gain 310 comportant au moins le milieu à gain 321, la structure à gain 310 étant en contact avec la première couche diélectrique 110 en présentant une portion centrale de la structure à gain 310 en regard de la troisième section 213 et une première et une deuxième extrémité en regard de la deuxième et la quatrième section 212, 214, ainsi, la portion centrale de la structure à gain 310 forme avec la troisième section de guide d'onde 213 un guide d'onde hybride laser 313, les deuxième et quatrième section de guide d'onde 212, 214, et les première et deuxième extrémités de la structure à gain 310 formant une première et une deuxième zone de transition optique 312, 314 d'un mode optique entre le guide d'onde hybride laser 313 et respectivement la première et la cinquième sections de guide d'onde 211, 215, le dispositif photonique 1 étant ainsi formé, lors de ladite formation de la structure, la première partie e1 de l'épaisseur de la troisième section sur laquelle est aménagée la structuration étant située à distance de la première couche diélectrique 110, comme illustré sur la figure 5F.

Dans le cadre d'un tel procédé de fabrication et selon une possibilité non illustrée, il est également envisageable de prévoir une étape d'amincissement partiel de la première couche diélectrique 110. Une telle étape d'amincissement de la première couche diélectrique 110 peut être soit une étape de gravure chimique, une étape de gravure sèche, ou une étape de polissage mécano chimique, ou une combinaison de ces étapes, ceci afin de conserver un contrôle optimale de l'amincissement de l'épaisseur de la première couche diélectrique 110.

Dans le cadre d'un tel procédé de fabrication et selon une possibilité non illustrée, il est également envisageable de prévoir une étape de retrait partiel ou total de la première couche diélectrique 110, par gravure sèche ou chimique et une étape de formation d'une première couche diélectrique alternative 110 par dépôt ou report d'un matériau diélectrique en complément ou en remplacement de la couche diélectrique partiellement ou totalement amincie, suivie par une éventuelle étape planarisation de cette première couche diélectrique alternative 110.

On notera bien entendu que si dans ce premier mode de réalisation le premier guide d'onde 210 et les première à cinquième section de guide d'onde 211, 212, 213, 214, 215 sont formés par gravure de la couche de silicium 201, il est également envisageable, en variante de ce premier mode de réalisation, qu'une seule partie de l'épaisseur du premier guide d'onde 210 et des première à la troisième sections de guide d'onde 211, 212, 213, 214, 215, par exemple la deuxième épaisseur, soit formée dans la couche de silicium 201, le reste étant fourni par le dépôt d'une deuxième couche de silicium non illustrée. Selon cette variante, la structuration de la couche de silicium 201 peut être antérieure ou postérieure au dépôt de la deuxième couche semiconductrice 320, cette dernière pouvant être alors structurée soit directement au dépôt, par dépôt au travers d'un masque dur, soit par gravure postérieure au dépôt.

Selon cette variante, en lieu et place de l'étape de structuration de la couche de silicium 201 pour former le premier guide d'onde 210 et des première à cinquième sections de guide d'onde 211, 212, 213, 214, 215 distinctes du premier guide d'onde 210 il peut être prévu les étapes suivantes :

- structuration de la couche de silicium 201 pour former une deuxième partie e2 de l'épaisseur du premier guide d'onde 210 et des première à cinquième sections de guide d'onde 211, 212, 213, 214, 215 distinctes du premier guide d'onde 210,

- formation dans une couche de silicium complémentaire d'une première partie e1 d'épaisseur du premier guide d'onde 210 et des première à cinquième sections de guide d'onde 211, 212, 213, 214, 215 distinctes du premier guide d'onde 210.

Selon cette variante de l'invention, l'étape de formation dans la couche de silicium de la première partie e1 d'épaisseur du premier guide d'onde 210 et des première à cinquième sections 211, 212, 213, 214, 215 peut comprendre les sous étapes suivantes :

- enterrement de la deuxième partie e2 d'épaisseur du premier guide d'onde 210 et des première à cinquième sections de guide d'onde 211, 212, 213, 214, 215, par le matériau diélectrique de remplissage 205 et planarisation dudit matériau diélectrique 205,
- formation de la couche de silicium complémentaire en contact de la deuxième partie e2 d'épaisseur du premier guide d'onde 210 et des première à cinquième sections de guide d'onde 211, 212, 213, 214, 215,
- structuration de la couche de silicium complémentaire pour former la première partie e1 d'épaisseur du premier guide d'onde 210 et des première à cinquième sections de guide d'onde 211, 212, 213, 214, 215.

On notera que la sous-étape de formation de la couche de silicium complémentaire peut être aussi bien une sous-étape de dépôt de ladite couche de silicium complémentaire qu'une sous-étape de report d'une telle couche de silicium complémentaire.

Les figures 6A à 6D illustrent, par respectivement une vue de dessus, une vue en coupe longitudinale selon le plan XX', et deux vue en coupe transversale selon les plans Y1Y1' et Y2Y2' et de manière plus précise, l'étape de structuration de la couche de silicium 201 pour former le premier guide d'onde 210 et les première au cinquième sections de guide d'onde 211, 212, 213, 214, 215.

On peut ainsi voir sur la figure 6A les corrugations latérales de la troisième section de guide d'onde 213 formées sur une première épaisseur e1 de la troisième section de guide d'onde 213, ces corrugations étant formées en contact de la deuxième partie e2 de la troisième section de guide d'onde 213, comme le montrent clairement les figures 6C et 6D.

Les figures 7A et 7B illustrent un dispositif photonique 1 selon un deuxième mode de réalisation dans lequel la première zone semiconductrice 331, la deuxième zone semiconductrice 341 et le milieu à gain 321 présentent chacune, sur sa longueur respective, une section transversale constante sur toute la longueur de la structure à gain 310. Un tel dispositif photonique 1 se différencie d'un dispositif photonique selon le premier mode de réalisation de par la forme de la structure à gain 310. Une telle section transversale constante permet de fournir des zones de transitions particulièrement adaptées à une épaisseur de couche de silicium 201 supérieure à 500 nm, et par exemple égale à 700 nm.

On notera que le procédé de fabrication d'un dispositif photonique 1 selon ce deuxième mode de réalisation de l'invention se différencie d'un dispositif photonique 1 selon le premier mode de réalisation en ce que lors de l'étape gravure partielle des première, deuxième et troisième couches semiconductrices 340, 320, 320, la structure à gain 310 s'étend longitudinalement selon un axe de propagation optique du dispositif optique 1 et la première zone semiconductrice 331, la deuxième zone semiconductrice 341 et le milieu gain 321 présente, sur leur longueur respectif, une section transversale de largeur constante.

Les figures 8A et 8B illustrent une vue en de dessus et une vue en coupe longitudinale selon le plan XX' d'un dispositif photonique selon un troisième mode de réalisation dans lequel le laser 300 comporte une structure de contre réaction optique fournie par un réseau de Bragg distribué du type à « corrugations verticales ». Un tel dispositif photonique se différencie d'un dispositif selon le premier mode de réalisation de par le type de structuration de la troisième section de guide d'onde 213.

En effet, comme le montrent les figure 8A et 8B, dans ce troisième mode de réalisation la deuxième largeur WN de la structuration de la troisième section de guide d'onde 213 est nulle.

Ainsi, on obtient une structuration dans la troisième section de guide d'onde 213 réalisée sur la première partie e1 de son épaisseur située à distance de la première couche diélectrique 110 et qui peut présenter, par exemple une épaisseur de 150 nm. Cette première partie e1 de l'épaisseur correspond à l'épaisseur de la section transversale de l'arête de la troisième section de guide d'onde 213. La structure de contre réaction présente une épaisseur variant ainsi entre une épaisseur nulle, et une épaisseur e1 non nulle correspondant à celle de la première partie e1 de la troisième section de guide d'onde 213 La période d'alternance entre l'épaisseur nulle et l'épaisseur de la première partie e1 d'épaisseur, selon le principe d'un réseau de Bragg, est sensiblement égale à $\lambda/2n_{eff}$, $\lambda$ étant la longueur d'onde d'émission du laser 300. La deuxième partie e2 d'épaisseur de la troisième section de guide d'onde 213 présente une épaisseur constante et forme l'embase de la troisième section de guide d'onde 213.

Comme le montrent les figures 9A à 9E qui illustrent par des vues en coupe longitudinales (selon le plan XX' de la figure 8A) les principales étapes d'un procédé de fabrication d'un dispositif photonique 1 selon ce troisième mode de réalisation, un tel procédé de fabrication se différentie du procédé de fabrication d'un dispositif photonique selon le premier mode de réalisation en ce que, comme illustré sur la figure 9B, lors de l'étape de structuration de la couche de silicium 201 pour former le premier guide d'onde 210 et des première à cinquième sections de guide d'onde 211, 212, 213, 214, 215, la structuration de la section de la troisième section de guide d'onde est réalisée de telle manière à ce que la deuxième largeur WN est nulle.

On notera ainsi, comme illustré sur la figure 9A, que l'étape de fourniture d'un substrat 100 est identique et que les étapes qui suivent l'étape de structuration de la couche de silicium 201 pour former le premier guide d'onde 210 et des première à cinquième sections de guide d'onde 211, 212, 213, 214, 215, présentent comme unique différence, comme illustré sur les figures 9C à 9E, la forme de la structure de contre réaction qui est un réseau de Bragg à corrugations verticales.

Les figures 10A et 10B illustrent respectivement une vue de dessus et une vue en coupe longitudinale selon le plan XX' d'un dispositif photonique 1 selon un quatrième mode de réalisation de l'invention dans lequel la structure de contre-réaction optique est un réseau de Bragg 223 à corrugations verticales et dans lequel la première zone semiconductrice 331, la deuxième zone semiconductrice 341 et le milieu à gain 321 présentent chacune, sur sa longueur respective, une section transversale constante sur toute la longueur de la structure à gain 310. Un tel dispositif photonique 1 se différencie d'un dispositif photonique selon le troisième mode de réalisation de par la forme de la structure à gain 310.

On notera que le procédé de fabrication d'un dispositif photonique 1 selon ce quatrième mode de réalisation de l'invention se différencie d'un dispositif photonique 1 selon le troisième mode de réalisation en ce que lors de l'étape gravure partielle des première, deuxième et troisième couches semiconductrices 340, 320, 330, la structure à gain 310 s'étend longitudinalement selon un axe de propagation optique du dispositif optique 1 et la première zone semiconductrice 331, la deuxième zone semiconductrice 341 et le milieu gain 321 présente, sur leur longueur respectif, une section transversale de largeur constante.

Les figures 11A à 11D illustrent, par respectivement une vue en coupe longitudinale selon le plan XX' et trois vues en coupe transversale selon les plans Y1Y1', Y4Y4', Y5Y5', un dispositif photonique 1 selon un cinquième mode de réalisation dans lequel il prévu un modulateur optique 230 hybride du type capacitif. Un dispositif photonique 1 selon ce cinquième mode de réalisation se différencie d'un dispositif photonique 1 selon le troisième mode de réalisation en ce que le premier guide d'onde 210 accommode un modulateur optique 230 du type capacitif et un réseau de couplage 240 partiellement gravé dans la couche de silicium 201. On notera que les figures 11A à 11D montrent la couche d'encapsulation 510 et les contacts électriques du laser 300 et du modulateur capacitif 230.

Ainsi on peut voir sur la figure 11A, que la couche de silicium 201 comporte en outre une zone de silicium dopée 232, en relation avec une quatrième zone semiconductrice 231, et un réseau de couplage 240 pour extraire le rayonnement en sortie du dispositif photonique 1. Le réseau de couplage est un réseau à structurations bidimensionnelle dans la couche de silicium 201.

Le dispositif photonique 1 comporte en outre la quatrième zone semiconductrice 231 qui, formée dans la première couche semiconductrice 340 dans laquelle est également formée la première zone semiconductrice 341, est en regard de la zone de silicium dopée 232. La quatrième zone semiconductrice 231 est en contact avec la deuxième face de la première couche diélectrique 110. De cette manière, la quatrième zone semiconductrice 231, la zone de silicium dopée 232 et la partie de la couche diélectrique 110 qui les sépare forment ensemble le modulateur optique 230 hybride de type capacitif.

Le procédé de fabrication d'un dispositif photonique 1 selon ce quatrième mode de réalisation se différencie d'un procédé de fabrication selon le deuxième mode de réalisation en ce que :

- lors de la structuration de la couche de silicium 201, il est également formé le réseau de couplage 240 accommodé dans le premier guide d'onde 210 et la partie du premier guide d'onde 210 destinée à former la zone de silicium dopée 232 du modulateur capacitif 230,

- il est prévu une étape de dopage localisé de la couche de silicium 201 afin de former la zone de silicium dopée 232 d'un type de conductivité opposée au type de conductivité de la quatrième zone semiconductrice 231, et

- lors de la formation de la structure à gain 310, il est également formé la quatrième zone semiconductrice 231 en regard de la zone de silicium dopée 232 afin de former le modulateur capacitif 230, et

- il est prévu des étapes d'encapsulation de la structure à gain dans un ou plusieurs matériaux diélectriques pour former la couche d'encapsulation 510 et de formation des contacts métalliques 531, 532, 533, 534.

Sur la figure 11C, le matériau diélectrique 205 et des parties en matériaux diélectriques de la couche intermédiaire 420 logent un via métallique 235 connectant électriquement 232 une ligne métallique 435 également logé dans le matériau diélectrique 205 et/ou dans couche intermédiaire 420. Un via électrique 515, accommodé dans la couche d'encapsulation 510, et traversant la première couche diélectrique 110, est en contact électrique avec la ligne métallique 435, permettant ainsi de fournir les contacts électriques 534, 533 des composants actifs accommodés dans le premier guide d'onde 210, sur la face externe de la couche d'encapsulation.

On peut voir sur la figure 11B, que le premier contact électrique 531 est constitué d'un contact métallique en contact avec la surface de la première zone semiconductrice 331 et adapté pour former avec celle-ci un contact ohmique. Le contact métallique latéral du premier contact électrique 531 débouche dans une deuxième face de la couche d'encapsulation 510 qui est opposée à la première couche diélectrique 110. Le deuxième contact électrique 532 comporte un contact métallique pour contacter la deuxième zone semiconductrice 341 et adapté pour former un contact ohmique avec cette dernière. Le deuxième contact électrique 532 comporte en outre un via métallique en contact avec le contact métallique et traversant la couche d'encapsulation 510 en débouchant sur la deuxième face de la couche d'encapsulation 510.

Les figures 12A à 12C illustrent, par respectivement une vue de dessus, une vue en coupe longitudinale selon le plan XX' et une vue en coupe transversale selon le plan Y6Y6', un dispositif photonique selon un sixième mode de réalisation de l'invention dans lequel la structure à gain 310 est du type à « jonction latérale ». Un dispositif selon ce sixième mode de réalisation se différencie d'un dispositif phonique 1 selon le troisième mode de réalisation en ce que la structure à gain 310 est une structure à gain du type à « jonction latérale ».

La structure à gain 310 comporte, comme illustré sur la figure 12C successivement et selon une coupe transversale du guide d'onde hybride 313 le long de l'axe Y6Y6' :

- une première zone semiconductrice 341 d'un premier type de conductivité,
- un milieu à gain 321 comportant, par exemple, au moins une couche de puits quantiques, ou de boites quantiques,
- une troisième zone semiconductrice 331 d'un deuxième type de conductivité opposé au premier type de conductivité de la zone semiconductrice 341.

La structure à gain 310 comporte en outre, comme illustré sur les figures 12A à 12C, une première et une deuxième zone de couplage 351, 352 disposées de part et d'autre des première, deuxième et troisième zones semiconductrices 341, 331 selon la direction de propagation de la lumière, et une couche semiconductrice 353, également non intentionnellement dopée, s'interposant entre la première couche diélectrique et le reste de la structure à gain 310. La première et la deuxième zone de couplage 351, 352 correspondent ainsi chacune à une extrémité de la structure à gain 310 par l'intermédiaire desquelles la première et la deuxième zone de transition optique 312, 314 permettent une transmission adiabatique du mode optique entre le guide d'onde hybride laser 313 et respectivement la première et la cinquième section de guide d'onde 211, 215.

Le procédé de fabrication d'un dispositif photonique selon ce sixième mode de réalisation de l'invention se différencie du procédé de fabrication selon le premier mode de réalisation de l'invention en ce que :

- en ce que lors de l'étape de formation de la structure à gain 310, la structure à gain est une structure à « jonction latérale ».

La figure 13 illustre une vue en coupe transversale d'un dispositif photonique 1 selon un sixième mode de réalisation dans lequel le premier guide d'onde 210, et l'ensemble des première à cinquième sections de guide d'onde 211, 212, 213, 214, 215, comporte une troisième partie e3 d'épaisseur. Un tel dispositif photonique 1 se différencie d'un dispositif photonique selon le premier mode de réalisation en ce que chacun du premier guide d'onde 210 et des première à cinquième sections de guide d'onde 211, 212, 213, 214, 215 comprend une troisième partie d'épaisseur en contact avec la couche intermédiaire 420.

Une telle troisième partie d'épaisseur peut, par exemple, permettre que le premier guide d'onde accommode des composants électroniques.

Dans ce sixième mode de réalisation, la première partie e1 de l'épaisseur de la troisième section de guide d'onde 213 est disposée entre la deuxième partie e2 de l'épaisseur de la troisième section de guide d'onde 213, qui est en contact avec la première couche diélectrique 110, et la troisième partie de l'épaisseur de la troisième section de guide d'onde 213, qui est en contact avec la couche intermédiaire 420.

On notera que cette configuration de la troisième section de guide d'onde 213 est également partagée par le premier guide d'onde 210 et par les première, deuxième, quatrième et cinquième sections de guide d'onde 211, 212, 214, 215 qui présente leur arête respective disposée entre l'embase et la troisième partie e3 de leur épaisseur.

Un procédé de formation d'un dispositif photonique 1 selon ce sixième mode de réalisation se différencie d'un procédé de fabrication selon le premier mode de réalisation en ce qu'en lieu et place de l'étape de structuration de la couche de silicium 201 pour former le premier guide d'onde 210 et les première à cinquième sections de guide d'onde 211, 212, 213, 214, 215 distinctes du premier guide d'onde 210, il est prévu les étapes suivantes :

- structuration de la couche de silicium 201 pour former une première et deuxième partie e1, e2 de l'épaisseur du premier guide d'onde 210 et des première à cinquième sections de guide d'onde 211, 212, 213, 214, 215 distinctes du premier guide d'onde 210,
- formation d'une couche de silicium supplémentaire en contact de la première partie d'épaisseur du premier guide d'onde 210 et des première à cinquième sections de guide d'onde 211, 212, 213, 214, 215,
- structuration de la couche de silicium supplémentaire pour former la troisième partie e3 d'épaisseur du premier guide d'onde 210 et des première à cinquième sections de guide d'onde 211, 212, 213, 214, 215.

Bien entendu, lors de l'étape d'enterrement du premier guide d'onde 210 et des première à cinquième section de premier guide d'onde 211, 212, 213, 214, 215, la troisième partie d'épaisseur e3 du premier guide d'onde 210 est enterré dans ledit matériau diélectrique de remplissage 205.

Conformément, à ce sixième mode de réalisation, l'étape de formation dans la couche de silicium de la première partie e1 d'épaisseur du premier guide d'onde 210 et des première à cinquième sections 211, 212, 213, 214, 215 peut comprendre les sous étapes suivantes :

- enterrement de la deuxième partie e2 d'épaisseur du premier guide d'onde 210 et des première à cinquième sections de guide d'onde 211, 212, 213, 214, 215, par le matériau diélectrique de remplissage 205 et planarisation dudit matériau diélectrique 205,
- formation de la couche de silicium complémentaire en contact de la deuxième partie e2 d'épaisseur du premier guide d'onde 210 et des première à cinquième sections de guide d'onde 211, 212, 213, 214, 215,
- structuration de la couche de silicium complémentaire pour former la première partie e1 d'épaisseur du premier guide d'onde 210 et des première à cinquième sections de guide d'onde 211, 212, 213, 214, 215.

Ladite formation de la couche de silicium complémentaire peut être soit une sous-étape de dépôt de ladite couche de silicium complémentaire soit une sous-étape de report d'une telle couche de silicium complémentaire.

Bien entendu, si un dispositif photonique 1 selon ce sixième mode de réalisation présente une configuration conforme au premier mode de réalisation excepté la présence de la troisième partie d'épaisseur e3 du premier guide d'onde 210 et des première à cinquième sections de guide d'onde 211, 212, 213, 214, 215, une telle configuration d'un premier guide d'onde 210 et de premier à cinquième sections de guide d'onde 211, 212, 213, 214, 215 est également compatible avec les dispositifs photoniques 1 selon les deuxième au cinquième modes de réalisation.

## Revendications

**1.** Dispositif photonique (1) comportant :

    - un support (120),
    - une couche intermédiaire (420) en contact avec le support (120) comportant au moins un matériau diélectrique,
    - un premier guide d'onde (210),
    - une première à une cinquième section de guide d'onde (211, 212, 213, 214, 215) distinctes du premier guide d'onde (210), la première à la cinquième section de guide d'onde se succédant en étant connectées optiquement deux à deux, et étant connectées optiquement au premier guide d'onde (210) par au moins l'une de la première et de la cinquième section de guide d'onde (211, 215),
    - un matériau diélectrique de remplissage (205), pour former avec le premier guide d'onde (210) et la première à la cinquième section de guide d'onde (211, 212, 213, 214, 215) un étage de guidage d'onde (200) du dispositif photonique (1), l'étage de guidage optique comprenant une première face (200A) par laquelle il est en contact avec la couche intermédiaire (420) et une deuxième face (200B) opposée à la première face (200A),
    - une première couche diélectrique (110) comportant un matériau diélectrique, la première couche diélectrique (110) recouvrant l'étage de guidage optique sur sa deuxième face (200B),
    - une structure à gain (310) en contact avec la première couche diélectrique (110) et comportant au moins un milieu à gain (321) apte à émettre de la lumière, la structure à gain (310) présentant une portion centrale en regard de la troisième section de guide d'onde (213) et une première et une deuxième extrémité en regard des deuxième et quatrième sections de guide d'onde (212, 214), ainsi, la portion centrale de la structure à gain (310) forme avec la troisième section de guide d'onde (213) un guide d'onde hybride laser (313), les deuxième et quatrième sections de guide d'onde (212, 214) et les première et deuxième extrémités de la structure à gain (310) formant une première et une deuxième zone de transition optique (312, 314) d'un mode optique entre le guide d'onde hybride laser (313) et respectivement la première et la cinquième sections de guide d'onde (211, 215),
    dans lequel la troisième section (213) est en contact avec la couche intermédiaire (420) et comprend une structuration aménagée uniquement dans une première partie (e1) de son épaisseur, ladite structuration formant un réseau de Bragg (223) distribué sous la structure à gain (310) pour former une structure de contre réaction et une cavité résonante comprenant au moins une partie du milieu à gain (321) ceci de manière à former un laser (300) connecté optiquement au guide d'onde (210) par au moins l'une de la première et la cinquième section de guide d'onde (211, 215),
    dans lequel les deuxième et quatrième sections de guide d'onde (212, 214) sont en contact avec la couche intermédiaire (420) sur une partie de la couche intermédiaire (420) qui est constituée uniquement de matériaux diélectriques,

le dispositif photonique **étant caractérisé en ce que** la troisième section de guide d'onde (213) comprend au moins une deuxième partie (e2) de son épaisseur qui sépare la première couche diélectrique (110) et la première partie (e1) de l'épaisseur de la troisième section de guide d'onde (213).

2. Dispositif photonique (1) selon la revendication 1, dans lequel la première partie (e1) de l'épaisseur de la troisième section de guide d'onde (213) est en contact avec la couche intermédiaire (420).

3. Dispositif photonique (1) selon la revendication 1, dans lequel la troisième section de guide d'onde comprend au moins une troisième partie (e3) de son épaisseur, ladite troisième partie (e3) d'épaisseur étant en contact avec couche intermédiaire (420).

4. Dispositif photonique (1) selon l'une quelconque des revendication 1 à 3, dans laquelle l'épaisseur de la première couche diélectrique (110) est inférieure ou égale à 100 nm, l'épaisseur de la première couche diélectrique (110) étant préférentiellement inférieure ou égale à 90 nm, voire à 70 nm, voire à 20 nm.

5. Dispositif photonique (1) selon l'une quelconque des revendications 1 à 4, dans lequel la troisième section de guide d'onde (213) s'étend longitudinalement le long d'un axe de propagation optique du dispositif optique (1) et dans lequel la structuration de la troisième section (213) consiste en une alternance entre une section transversale d'une première largeur (WL) et une section transversale d'une seconde largeur (WN) différente de la première largeur (WL).

6. Dispositif photonique (1) selon la revendication 5, dans lequel la seconde largeur (WN) est de valeur nulle.

7. Dispositif photonique (1) selon l'une quelconque des revendications 1 à 6, dans lequel la structure à gain (310) s'étend longitudinalement selon un axe de propagation optique du dispositif optique (1), et dans lequel chacune de la première et de la deuxième extrémité de la structure à gain (310) présente, sur au moins une partie de son épaisseur et selon une direction longitudinale allant en s'éloignant de la portion centrale, une section transversale de largeur décroissante.

8. Dispositif photonique (1) selon l'une quelconque des revendications 1 à 6, dans lequel la structure à gain (310) s'étend longitudinalement selon un axe de propagation optique du dispositif optique (1) et comporte une première zone semiconductrice (331), une deuxième zone semiconductrice (341) et le milieu à gain (321),

et dans lequel, pour chacune de la première et la deuxième extrémité de la structure à gain (310), la première zone semiconductrice (331), la deuxième zone semiconductrice (341) et le milieu gain (321) présente, sur leur longueur respective, une section transversale de largeur constante.

9. Dispositif photonique (1) selon l'une quelconque des revendications 1 à 8, dans lequel dans lequel le guide d'onde (210) accommode au moins un composant optique et/ou électronique,

dans lequel le composant optique est préférentiellement choisi dans le groupe comportant les modulateurs optiques silicium à jonction PN, les modulateurs hybrides semiconducteur III-V sur silicium, les réseaux de couplage surfaciques, les coupleurs à fibre par la tranche du dispositif, les filtres optiques, les multiplexeurs et démultiplexeurs en longueurs d'onde, et les photodétecteurs dont font partie les photodétecteurs germanium sur silicium et les photodétecteurs semiconducteur III-V sur silicium, et dans lequel le composant électronique est préférentiellement un transistor.

10. Dispositif photonique (1) selon la revendication 9, dans lequel le composant accommodé par le guide d'onde est un modulateur hybride semiconducteur III-V sur silicium, ledit modulateur étant un modulateur capacitif.

11. Procédé de fabrication d'un dispositif photonique (1) comportant au moins un guide d'onde en silicium (210) et un laser (300) comprenant un milieu à gain (321) apte à émettre de la lumière, le procédé comportant les étapes suivantes :

    - fourniture d'un substrat (100) associé avec au moins une couche de silicium (201) sur une première couche diélectrique (110),
    - formation, au moins en partie dans la couche de silicium (201), d'un premier guide d'onde (210) et des première à cinquième sections de guide d'onde (211, 212, 213, 214, 215) distinctes du premier guide d'onde (210), la première à la cinquième section de guide d'onde (211, 212, 213, 214, 215) se succédant connectées optiquement deux à deux, et étant connectées optiquement au premier guide d'onde (210) par au moins l'une de la première et la cinquième section de guide d'onde (211, 215), la troisième section (213) comprenant une structuration aménagée uniquement sur une première partie (e1) de son épaisseur, ladite structuration formant un réseau de Bragg (223),
    - enterrement du guide d'onde (210) et des première à cinquième section de guide d'onde (211, 212, 213, 214, 215) par au moins un matériau diélectrique de remplissage (205) et planarisation dudit matériau diélectrique de remplissage (205) afin de former un étage de guidage optique (200) comprenant le guide d'onde (210) et les première à cinquième section de guide d'onde (211, 212, 213, 214, 215) et une couche intermédiaire (420) en contact avec ledit étage de guidage optique, la troisième section (213) étant en contact avec la couche intermédiaire (420), les deuxième et quatrième section de guide d'onde (212, 214) étant en contact avec la couche intermédiaire (420) sur une partie de la couche intermédiaire qui est constituée uniquement de matériaux diélectriques, un ensemble substrat (100)/ première couche diélectrique (110)/ étage de guidage optique (200)/ couche intermédiaire (420) étant ainsi formé,

- fourniture d'un support (120),

- assemblage de l'ensemble substrat (100)/ première couche diélectrique (110)/ étage de guidage optique (200)/ couche intermédiaire (420) sur le support (120), l'assemblage étant réalisé par collage de la couche intermédiaire sur le support (120),

- suppression du substrat (100),

- formation d'une structure à gain (310) comportant au moins le milieu à gain (321), la structure à gain (310) étant formée en contact avec la première couche diélectrique (110) en présentant une portion centrale de la structure à gain (310) en regard de la troisième section (213) et une première et une deuxième extrémité en regard de la deuxième et la quatrième section (212, 213), ainsi, la portion centrale de la structure à gain (310) forme avec la troisième section de guide d'onde (213) un guide d'onde hybride laser (313), les deuxième et quatrième sections de guide d'onde (212, 214), et les première et deuxième extrémités de la structure à gain (310) formant une première et une deuxième zone de transition optique (312, 314) d'un mode optique entre le guide d'onde hybride laser (313) et respectivement la première et la cinquième section de guide d'onde (211,215), le dispositif photonique (1) étant ainsi formé, lors de ladite formation de la structure, la première partie (e1) de l'épaisseur de la troisième section sur laquelle est aménagée la structuration étant séparée de la première couche diélectrique (110) par au moins une deuxième partie (e2) de l'épaisseur de la troisième section (213).

**12.** Procédé de fabrication d'un dispositif photonique (1) selon la revendication 11, dans lequel l'étape de formation, au moins en partie dans la couche de silicium (201), du premier guide d'onde (210) et des première à cinquième sections de guide d'onde (211, 212, 213, 214, 215) distinctes du premier guide d'onde (210) comprend les sous étapes suivantes :

- structuration de la couche silicium (201) pour former une deuxième partie (e2) d'épaisseur du guide d'onde (210) et des première à cinquième sections de guide d'onde (211, 212, 213, 214, 215),

- formation à partir d'une couche de silicium complémentaire d'une première partie (e1) d'épaisseur du guide d'onde (210) et des première à cinquième sections de guide d'onde (211, 212, 213, 214, 215).

**13.** Procédé de fabrication selon la revendication 11 ou 12, dans lequel il est en outre prévu une étape d'amincissement de la première couche diélectrique (110) entre les étapes de suppression du substrat (100) et de formation de la structure à gain (310).

**14.** Procédé de fabrication selon la revendication 13, dans lequel après l'étape d'amincissement de la première couche diélectrique (110), la première couche diélectrique (110) présente une épaisseur inférieure ou égale à 110 nm, l'épaisseur de la première couche diélectrique (110) étant préférentiellement inférieure ou égale à 90 nm, voire à 70 nm, voire à 20 nm.

**15.** Procédé de fabrication selon l'une quelconque des revendications 11 à 14, dans lequel lors de l'étape de formation de la structure à gain, la structure à gain (310) s'étend longitudinale selon un axe de propagation optique du dispositif optique (1) et la première et la deuxième extrémité de la structure à gain (310) présentent, sur au moins une partie de leur épaisseur et selon une direction longitudinale allant en s'éloignant de la portion centrale, une section transversale de largeur décroissante.

**16.** Procédé de fabrication selon l'une quelconque des revendications 11 à 15, lequel lors de l'étape de formation de la structure à gain, la structure à gain (310) s'étend longitudinale selon un axe de propagation optique du dispositif optique (1) et comporte une première zone semiconductrice (331), une deuxième zone semiconductrice (341) et le milieu à gain (321), et

dans lequel, pour chacune de la première et la deuxième extrémité de la structure à gain, la première zone semiconductrice (331), la deuxième zone semiconductrice (341) et le milieu gain (321) présentent, sur leur longueur respective, une section transversale de largeur constante.

## Patentansprüche

**1.** Photonische Vorrichtung (1), umfassend:

- einen Träger (120),
- eine Zwischenschicht (420) in Kontakt mit dem Träger (120), umfassend wenigstens ein dielektrisches Material,

- einen ersten Wellenleiter (210),

- einen ersten bis einen fünften Wellenleiterabschnitt (211, 212, 213, 214, 215), die von dem ersten Wellenleiter (210) verschieden sind, wobei der erste bis der fünfte Wellenleiterabschnitt aufeinander folgen, wobei sie optisch paarweise verbunden sind, und sie optisch mit dem ersten Wellenleiter (210) mittels wenigstens eines von dem ersten und dem fünften Wellenleiterabschnitt (211, 215) verbunden sind,

- ein dielektrisches Füllmaterial (205), um mit dem ersten Wellenleiter (210) und dem ersten bis dem fünften Wellenleiterabschnitt (211, 212, 213, 214, 215) eine Wellenleitungsstufe (200) der photonischen Vorrichtung (1) zu bilden, wobei die optische Leitungsstufe eine erste Fläche (200A) umfasst, mittels derer sie in Kontakt mit der Zwischenschicht (420) ist, und eine zweite Fläche (200B) entgegengesetzt zu der ersten Fläche (200A),

- eine erste dielektrische Schicht (110), umfassend ein dielektrisches Material, wobei die erste dielektrische Schicht (110) die optische Leitungsstufe auf ihrer zweiten Fläche (200B) bedeckt,

- eine Verstärkungsstruktur (310) in Kontakt mit der ersten dielektrischen Schicht (110) und umfassend wenigstens ein Verstärkungsmedium (321), das dazu ausgelegt ist, Licht zu emittieren, wobei die Verstärkungsstruktur (310) einen Zentralbereich gegenüber dem dritten Wellenleiterabschnitt (213) aufweist sowie ein erstes und ein zweites Ende gegenüber dem zweiten und dem vierten Wellenleiterabschnitt (212, 214), derart, dass der Zentralbereich der Verstärkungsstruktur (310) mit dem dritten Wellenleiterabschnitt (213) einen Hybridlaserwellenleiter (313) bildet, wobei der zweite und der vierte Wellenleiterabschnitt (212, 214) und das erste und das zweite Ende der Verstärkungsstruktur (310) eine erste und eine zweite optische Übergangszone (312, 314) einer optischen Mode zwischen dem Hybridlaserwellenleiter (313) und dem ersten beziehungsweise dem fünften Wellenleiterabschnitt (211, 215) bilden, wobei der dritte Abschnitt (213) in Kontakt mit der Zwischenschicht (420) ist und eine ausgebaute Strukturierung ausschließlich in einem ersten Teil (e1) seiner Dicke umfasst, wobei die Strukturierung ein Bragggitter (223) bildet, das unter der Verstärkungsstruktur (310) verteilt ist, um eine Gegenreaktionsstruktur zu bilden, und einen Resonanzhohlraum, der wenigstens einen Teil des Verstärkungsmediums (321) derart umfasst, dass ein Laser (300) gebildet wird, der optisch mit dem Wellenleiter (210) mittels wenigstens eines von dem ersten und dem fünften Wellenleiterabschnitt (211, 215) verbunden ist, wobei der zweite und der vierte Wellenleiterabschnitt (212, 214) in Kontakt mit der Zwischenschicht (420) auf einem Teil der Zwischenschicht (420) sind, der ausschließlich aus dielektrischen Materialien gebildet ist, wobei die photonische Vorrichtung **dadurch gekennzeichnet ist, dass** der dritte Wellenleiterabschnitt (213) wenigstens einen zweiten Teil (e2) seiner Dicke umfasst, der die erste dielektrische Schicht (110) und den ersten Teil (e1) der Dicke des dritten Wellenleiterabschnitts (213) separiert.

2. Photonische Vorrichtung (1) nach Anspruch 1, bei der der erste Teil (e1) der Dicke des dritten Wellenleiterabschnitts (213) in Kontakt mit der Zwischenschicht (420) ist.

3. Photonische Vorrichtung (1) nach Anspruch 1, bei der der dritte Wellenleiterabschnitt wenigstens einen dritten Teil (e3) seiner Dicke umfasst, wobei der dritte Teil (e3) der Dicke in Kontakt mit der Zwischenschicht (420) ist.

4. Photonische Vorrichtung (1) nach einem der Ansprüche 1 bis 3, bei der die Dicke der ersten dielektrischen Schicht (110) kleiner oder gleich 100 nm ist, wobei die Dicke der ersten dielektrischen Schicht (110) vorzugsweise kleiner oder gleich 90 nm oder auch als 70 nm oder aber als 20 nm ist.

5. Photonische Vorrichtung (1) nach einem der Ansprüche 1 bis 4, bei der der dritte Wellenleiterabschnitt (213) sich longitudinal entlang einer optischen Ausbreitungsachse der optischen Vorrichtung (1) erstreckt, und bei der die Strukturierung des dritten Abschnitts (213) aus einer Alternierung zwischen einem transversalen Abschnitt einer ersten Breite (WL) und einem transversalen Abschnitt einer zweiten Breite (WN) besteht, die von der ersten Breite (WL) verschieden ist.

6. Photonische Vorrichtung (1) nach Anspruch 5, bei der die zweite Breite (WN) den Wert Null hat.

7. Photonische Vorrichtung (1) nach einem der Ansprüche 1 bis 6, bei der die Verstärkungsstruktur (310) sich longitudinal entlang einer optischen Ausbreitungsachse der optischen Vorrichtung (1) erstreckt, und bei der jedes von dem ersten und dem zweiten Ende der Verstärkungsstruktur (310) wenigstens auf einem Teil seiner Dicke und entlang einer longitudinalen Richtung, die vom Zentralbereich weg verläuft, einen transversalen Querschnitt mit abnehmender Breite aufweist.

8.  Photonische Vorrichtung (1) nach einem der Ansprüche 1 bis 6, bei der die Verstärkungsstruktur (310) sich longitudinal entlang einer optischen Ausbreitungsachse der optischen Vorrichtung (1) erstreckt und eine erste Halbleiterzone (331), eine zweite Halbleiterzone (341) und das Verstärkungsmedium (321) umfasst,
    und bei der für jedes von dem ersten und dem zweiten Ende der Verstärkungsstruktur (310) die erste Halbleiterzone (331), die zweite Halbleiterzone (341) und das Verstärkungsmedium (321) auf ihrer jeweiligen Länge einen transversalen Querschnitt mit konstanter Breite aufweist.

9.  Photonische Vorrichtung (1) nach einem der Ansprüche 1 bis 8, bei der der Wellenleiter (210) wenigstens eine optische und/oder elektronische Komponente aufnimmt,
    bei der die optische Komponente vorzugsweise ausgewählt ist aus der Gruppe umfassend die optischen Siliziummodulatoren mit PN-Übergang, die Halbleiterhybridmodulatoren III-V auf Silizium, die Oberflächenkopplungsgitter, die Vorrichtungskantenfaserkoppler, die optischen Filter, die Wellenlängenmultiplexierer und -demultiplexierer, und die Photodetektoren, zu denen die Germanium-auf-Silizium-Photodetektoren und die Halbleiterphotodetektoren III-V auf Silizium gehören, und
    bei der die elektronische Komponente vorzugsweise ein Transistor ist.

10. Photonische Vorrichtung (1) nach Anspruch 9, bei der die von dem Wellenleiter aufgenommene Komponente ein Halbleiterhybridmodulator III-V auf Silizium ist, wobei der Modulator ein kapazitiver Modulator ist.

11. Verfahren zur Herstellung einer photonischen Vorrichtung (1), die wenigstens einen Siliziumwellenleiter (210) und einen Laser (300) umfasst, umfassend ein Verstärkungsmedium (321), das dazu ausgelegt ist, Licht zu emittieren, wobei das Verfahren die folgenden Schritte umfasst:

    - Bereitstellen eines Substrats (100), dem wenigstens eine Siliziumschicht (201) auf einer ersten dielektrischen Schicht (110) zugeordnet ist,
    - Bilden, wenigstens zum Teil in der Siliziumschicht (201), eines ersten Wellenleiters (210) und erster bis fünfter Wellenleiterabschnitte (211, 212, 213, 214, 215), die von dem ersten Wellenleiter (210) verschieden sind, wobei der erste bis der fünfte Wellenleiterabschnitt (211, 212, 213, 214, 215) optisch paarweise verbunden aufeinander folgen und optisch mit dem ersten Wellenleiter (210) mittels wenigstens eines von dem ersten und dem fünften Wellenleiterabschnitt (211, 215) verbunden sind, wobei der dritte Abschnitt (213) eine ausgebaute Strukturierung ausschließlich auf einem ersten Teil (e1) seiner Dicke umfasst, wobei die Strukturierung ein Bragggitter (223) bildet,
- Vergraben des Wellenleiters (210) und des ersten bis fünften Wellenleiterabschnitts (211, 212, 213, 214, 215) mittels wenigstens eines dielektrischen Füllmaterials (205) und Planarisieren des dielektrischen Füllmaterials (205), um eine optische Leitungsstufe (200) zu bilden, umfassend den Wellenleiter (210) und den ersten bis fünften Wellenleiterabschnitt (211, 212, 213, 214, 215) und eine Zwischenschicht (420) in Kontakt mit der optischen Leitungsstufe, wobei der dritte Abschnitt (213) in Kontakt mit der Zwischenschicht (420) ist, wobei der zweite und der vierte Wellenleiterabschnitt (212, 214) in Kontakt mit der Zwischenschicht (420) auf einem Teil der Zwischenschicht sind, der ausschließlich aus dielektrischen Materialien gebildet ist, wobei somit eine Gesamtanordnung Substrat (100)/ erste dielektrische Schicht (110)/ optische Leitungsstufe (200)/ Zwischenschicht (420) gebildet wird,
- Bereitstellen eines Trägers (120),
- Zusammenfügen der Gesamtanordnung Substrat (100)/ erste dielektrische Schicht (110)/ optische Leitungsstufe (200)/ Zwischenschicht (420) auf dem Träger (120), wobei das Zusammenfügen mittels Kleben der Zwischenschicht auf den Träger (120) realisiert wird,
- Entfernen des Substrats (100),
- Bilden einer Verstärkungsstruktur (310), die wenigstens das Verstärkungsmedium (321) umfasst, wobei die Verstärkungsstruktur (310) in Kontakt mit der ersten dielektrischen Schicht (110) gebildet wird, wobei sie einen Zentralbereich der Verstärkungsstruktur (310) gegenüber dem dritten Abschnitt (213) aufweist und ein erstes und ein zweites Ende gegenüber dem zweiten und dem vierten Abschnitt (212, 213), derart, dass der Zentralbereich der Verstärkungsstruktur (310) mit dem dritten Wellenleiterabschnitt (213) einen Hybridlaserwellenleiter (313) bildet, wobei der zweite und der vierte Wellenleiterabschnitt (212, 214) und das erste und das zweite Ende der Verstärkungsstruktur (310) eine erste und eine zweite optische Übergangszone (312, 314) einer optischen Mode zwischen dem Hybridlaserwellenleiter (313) und dem ersten beziehungsweise dem fünften Wellenleiterabschnitt (211, 215) bilden, wobei die photonische Vorrichtung (1) somit gebildet wird, wobei während des Bildens der Struktur der erste Teil (e1) der Dicke des dritten Abschnitts, auf dem die Strukturierung ausgebaut wird, von der ersten dielektrischen Schicht (110) mittels wenigstens eines zweiten Teils (e2) der Dicke des dritten Abschnitts (213) separiert ist.

12. Verfahren zur Herstellung einer photonischen Vorrichtung (1) nach Anspruch 11, bei dem der Schritt des Bildens des ersten Wellenleiters (210) wenigstens teilweise in der Siliziumschicht (201) und des ersten bis fünften Wellenleiterabschnitts (211, 212, 213, 214, 215), die von dem ersten Wellenleiter (210) verschieden sind, die folgenden Teilschritte umfasst.

- Strukturieren der Siliziumschicht (201) zum Bilden eines zweiten Teils (e2) der Dicke des Wellenleiters (210) und des ersten bis fünften Wellenleiterabschnitts (211, 212, 213, 214, 215),
- Bilden, ausgehend von einer komplementären Siliziumschicht, eines ersten Teils (e1) der Dicke des Wellenleiters (210) und des ersten bis fünften Wellenleiterabschnitts (211, 212, 213, 214, 215).

13. Herstellungsverfahren nach Anspruch 11 oder 12, bei dem ferner ein Schritt des Abdünnens der ersten dielektrischen Schicht (110) zwischen den Schritten des Entfernens der Substrats (100) und des Bildens der Verstärkungsstruktur (310) vorgesehen ist.

14. Herstellungsverfahren nach Anspruch 13, bei dem nach dem Schritt des Abdünnens der ersten dielektrischen Schicht (110) die erste dielektrische Schicht (110) eine Dicke kleiner oder gleich 110 nm aufweist, wobei die Dicke der ersten dielektrischen Schicht (110) vorzugsweise kleiner oder gleich 90 nm oder auch als 70 nm oder aber als 20 nm ist.

15. Herstellungsverfahren nach einem der Ansprüche 11 bis 14, bei dem während des Schritts des Bildens der Verstärkungsstruktur die Verstärkungsstruktur (310) sich longitudinal entlang einer optischen Ausbreitungsachse der optischen Vorrichtung (1) erstreckt, und das erste und das zweite Ende der Verstärkungsstruktur (310) wenigstens auf einem Teil ihrer Dicke und entlang einer longitudinalen Richtung, die von dem Zentralbereich weg verläuft, einen transversalen Querschnitt mit abnehmender Breite aufweisen.

16. Herstellungsverfahren nach einem der Ansprüche 11 bis 15, bei dem während des Schritts des Bildens der Verstärkungsstruktur die Verstärkungsstruktur (310) sich longitudinal entlang einer optischen Ausbreitungsachse der optischen Vorrichtung (1) erstreckt und eine erste Halbleiterzone (331), eine zweite Halbleiterzone (341) und das Verstärkungsmedium (321) umfasst, und bei dem für jedes von dem ersten und dem zweiten Ende der Verstärkungsstruktur die erste Halbleiterzone (331), die zweite Halbleiterzone (341) und das Verstärkungsmedium (321) auf ihrer jeweiligen Länge einen transversalen Querschnitt mit konstanter Breite aufweisen.

**Claims**

1. Photonic device (1) comprising:

- a support (120),
- an intermediate layer (420) in contact with the support (120) comprising at least one dielectric material,
- a first waveguide (210),
- a first to a fifth waveguide section (211, 212, 213, 214, 215) distinct from the first waveguide (210), the first to the fifth waveguide section succeeding each other while being optically connected two by two, and being optically connected to the first waveguide (210) by at least one of the first and the fifth waveguide sections (211, 215),
- a dielectric filling material (205), to form with the first waveguide (210) and the first to the fifth waveguide sections (211, 212, 213, 214, 215) a wave guiding level (200) of the photonic device (1), the optical guiding level including a first face (200A) through which it is in contact with the intermediate layer (420) and a second face (200B) opposite to the first face (200A),
- a first dielectric layer (110) comprising a dielectric material, the first dielectric layer (110) covering the optical guiding level on its second face (200B),
- a gain structure (310) in contact with the first dielectric layer (110) and comprising at least one gain medium (321) capable of emitting light, the gain structure (310) having a central portion facing the third waveguide section (213) and a first and a second end facing second and fourth waveguide sections (212, 214), thus, the central portion of the gain structure (310) forms with the third waveguide section (213) a laser hybrid waveguide (313), the second and fourth waveguide sections (212, 214) and the first and second ends of the gain structure (310) forming a first and a second zone of optical transition (312, 314) of an optic mode between the laser hybrid waveguide (313) and respectively the first and the fifth waveguide sections (211, 215), wherein the third section (213) is in contact with the intermediate layer (420) and includes a pattern arranged uniquely in a first part (e1) of its thickness, said pattern forming a distributed Bragg grating (223) under the gain structure (310) to form a feedback structure and a resonant cavity including at least one part of the gain medium (321) so doing so as to form a laser (300) optically connected to the waveguide (210) by at least one of the first and the fifth waveguide sections (211, 215),

wherein the second and fourth waveguide sections (212, 214) are in contact with the intermediate layer (420) on a part of the intermediate layer (420) which is constituted uniquely of dielectric materials,

the photonic device **being characterised in that** the third waveguide section (213) includes at least one second part (e2) of its thickness that separates the first dielectric layer (110) and the first part (e1) of the thickness of the third waveguide section (213).

2. Photonic device (1) according to claim 1, wherein the first part (e1) of the thickness of the third waveguide section (213) is in contact with the intermediate layer (420).

3. Photonic device (1) according to claim 1, wherein the third waveguide section includes at least one third part (e3) of its thickness, said third thickness part (e3) being in contact with the intermediate layer (420).

4. Photonic device (1) according to any of claims 1 to 3, wherein the thickness of the first dielectric layer (110) is less than or equal to 100 nm, the thickness of the first dielectric layer (110) preferentially being less than or equal to 90 nm, or even 70 nm, or even 20 nm.

5. Photonic device (1) according to any of claims 1 to 4, wherein the third waveguide section (213) extends longitudinally along an optical propagation axis of the optical device (1) and in which the pattern of the third section (213) consists in an alternation between a transversal section of a first width (WL) and a transversal section of a second width (WN) different from the first width (WL).

6. Photonic device (1) according to claim 5, wherein the second width (WN) is of zero value.

7. Photonic device (1) according to any of claims 1 to 6, wherein the gain structure (310) extends longitudinally along an optical propagation axis of the optical device (1),

and in which each of the first and the second ends of the gain structure (310) has, over at least one part of its thickness and along a longitudinal direction moving away from the central portion, a transversal section of decreasing width.

8. Photonic device (1) according to any of claims 1 to 6, wherein the gain structure (310) extends longitudinally along an optical propagation axis of the optical device (1) and comprises a first semiconductor zone (331), a second semiconductor zone (341) and the gain medium (321),

and in which, for each of the first and the second ends of the gain structure (310), the first semiconductor zone (331), the second semiconductor zone (341) and the gain medium (321) have, over their respective lengths, a transversal section of constant width.

9. Photonic device (1) according to any of claims 1 to 8, in which the waveguide (210) accommodates at least one optical and/or electronic component,

in which the optical component is preferentially chosen from the group comprising PN junction silicon optical modulators, hybrid III-V semiconductor on silicon modulators, surface coupling gratings, fibre couplers through the edge of the device, optical filters, wavelength multiplexers and demultiplexers, and photodetectors of which germanium on silicon photodetectors and III-V semiconductor on silicon photodetectors form part, and

in which the electronic component is preferentially a transistor.

10. Photonic device (1) according to claim 9, wherein the component accommodated by the waveguide is a hybrid III-V semiconductor on silicon modulator, said modulator being a capacitive modulator.

11. Method for manufacturing a photonic device (1) comprising at least one silicon waveguide (210) and a laser (300) including a gain medium (321) capable of emitting light, the method comprising the following steps:

- providing a substrate (100) associated with at least one silicon layer (201) on a first dielectric layer (110),
- forming, at least in part in the silicon layer (201), a first waveguide (210) and first to fifth waveguide sections (211, 212, 213, 214, 215) distinct from the first waveguide (210), the first to the fifth waveguide sections (211, 212, 213, 214, 215) succeeding each other optically connected two by two, and being optically connected to the first waveguide (210) by at least one of the first and the fifth waveguide sections (211, 215), the third section (213) including a pattern arranged uniquely over a first part (e1) of its thickness, said pattern forming a Bragg grating (223),
- burying the waveguide (210) and the first to fifth waveguide sections (211, 212, 213, 214, 215) by at least one dielectric filling material (205) and planarization of said dielectric filling material (205) in order to form an optical guiding level (200) including the waveguide (210) and the first to fifth waveguide sections (211, 212, 213, 214, 215) and an intermediate layer (420) in contact with said optical guiding level, the third section (213) being in contact with the intermediate layer (420), the second and fourth waveguide sections (212, 214) being in contact with the intermediate layer (420) on a part of the intermediate layer which is constituted uniquely of dielectric materials, a substrate (100)/ first dielectric layer (110)/ optical guiding level (200)/ intermediate layer (420) assembly thereby being formed,
- providing a support (120),
- assembling the substrate (100)/ first dielectric layer (110)/ optical guiding level (200)/ intermediate layer (420) assembly on the support (120), the assembly being carried out by bonding of the intermediate layer on the support (120),
- removal of the substrate (100),
- forming a gain structure (310) comprising at least the gain medium (321), the gain structure (310) being formed in contact with the first dielectric layer (110) while having a central portion of the gain structure (310) facing the third section (213) and a first and a second end facing the second and the fourth sections (212, 213), thus, the central portion of the gain structure (310) forms with the third waveguide section (213) a laser hybrid waveguide (313), the second and fourth waveguide sections (212, 214), and the first and second ends of the gain structure (310) forming a first and a second zone of optical transition (312, 314) of an optic mode between the laser hybrid waveguide (313) and respectively the first and the fifth waveguide sections (211,215), the photonic device (1) thereby being formed, during said formation of the structure, the first part (e1) of the thickness of the third section over which is arranged the pattern being separated from the first dielectric layer (110) by at least one second part (e2) of the thickness of the third section (213).

12. Method for manufacturing a photonic device (1) according to claim 11, wherein the step of forming, at least in part in the silicon layer (201), the first waveguide (210) and the first to fifth waveguide sections (211, 212, 213, 214, 215) distinct from the first waveguide (210) includes the following sub-steps:

- patterning the layer silicon (201) to form a second thickness part (e2) of the waveguide (210) and the first to fifth waveguide sections (211, 212, 213, 214, 215),
- forming from an additional silicon layer a first thickness part (e1) of the waveguide (210) and the first to fifth waveguide sections (211, 212, 213, 214, 215).

13. Manufacturing method according to claim 11 or 12, wherein a step of thinning the first dielectric layer (110) is further provided between the steps of eliminating the substrate (100) and of forming the gain structure (310).

14. Manufacturing method according to claim 13, wherein after the step of thinning the first dielectric layer (110), the first dielectric layer (110) has a thickness less than or equal to 110 nm, the thickness of the first dielectric layer (110) being preferentially less than or equal to 90 nm, or even 70 nm, or even 20 nm.

15. Manufacturing method according to any of claims 11 to 14, wherein during the step of forming the gain structure, the gain structure (310) extends longitudinally along an optical propagation axis of the optical device (1) and the first and the second ends of the gain structure (310) have, over at least one part of their thickness and along a longitudinal direction moving away from the central portion, a transversal section of decreasing width.

16. Manufacturing method according to any of claims 11 to 15, wherein during the step of forming the gain structure, the gain structure (310) extends longitudinally along an optical propagation axis of the optical device (1) and comprises a first semiconductor zone (331), a second semiconductor zone (341) and the gain medium (321), and
wherein, for each of the first and the second ends of the gain structure, the first semiconductor zone (331), the second semiconductor zone (341) and the gain medium (321) have, over their respective lengths, a transversal section of constant width.

FIG. 1
art antérieur

FIG. 2
Art anterieur

FIG. 3A

FIG. 3B

FIG. 3C

FIG. 3D

FIG. 4A

FIG. 4B
art antérieur

FIG. 4C

FIG. 4D
art antérieur

201

FIG. 5A

210 211 212 213 223 214 215

200

110 100 210

FIG. 5B

420
210 211 212 213 223 214 215

200

110 100 210

FIG. 5C

FIG. 5D

FIG. 5E

FIG. 5F

FIG. 6A

210  211  212  213  223  214  215

200

110  100  210

# FIG. 6B

213  223  $e_1$

$e_2$

110  100

$w_L$

# FIG. 6C

213  223  $e_1$

$e_2$

110  100

$w_N$

# FIG. 6D

FIG. 7A

FIG. 7B

FIG. 8A

FIG. 8B

FIG. 9A

FIG. 9B

FIG. 9C

FIG. 9D

FIG. 9E

FIG. 10A

FIG. 10B

FIG. 11A

EP 3 540 878 B1

FIG. 11B

FIG. 11C

FIG. 11D

FIG. 12A

FIG. 12B

## FIG. 12C

## FIG. 13

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 2988378 A

**Littérature non-brevet citée dans la description**

- **S. KEYVANINIA.** leurs travaux publiés en 2013 dans la revue scientifique. *Optics Letters,* 2013, vol. 38 (24), 5434-5437
- **H. DUPREZ.** dans le cadre de leurs travaux publiés en 2016 dans la revue scientifique. *IEEE Photonics Technology Letter,* 2016, vol. 28 (18), 1920-1923
- **S. KEYVANINIA et al.** Optics Letters. *la revue scientifique,* 2013
- **JASON S. ORCUTT.** Open foundry platform for high-performance electronic-photonic intégration. *Optics express,* 2012, vol. 20 (11), 12222-12232